# EUROPEAN PATENT APPLICATION

(11) **EP 4 766 142 A1**
(43) Date of publication of application: **24.06.2026**
(21) Application number: 25211618.1
(22) Date of filing: 28.10.2025
(51) Int. Cl.: H10W 70/685, H10W 70/63, H10W 44/00, H10W 70/692, H10W 76/42, H10W 90/00, H10W 70/05, H10W 70/60, H10W 74/10

(54) **PACKAGE SUBSTRATES WITH COMPONENTS INCLUDED IN CAVITIES OF GLASS CORES**

(30) Priority: 17.12.2024 US 202418984444
(71) Applicant: Intel Corporation, Santa Clara, CA 95054 (US)
(72) Inventor: MARIN, Brandon Christian, Gilbert 85234 (US); BRYKS, Whitney, Chandler 85249 (US); DUAN, Gang, Chandler 85248 (US); ECTON, Jeremy, Gilbert 85298 (US); GAMBA, Jason, Gilbert 85298 (US); HARIRI, Haifa, Phoenix 85045 (US); KANDANUR, Sashi Shekhar, Chandler 85226 (US); PEOPLES, Joseph, Gilbert 85296 (US); PIETAMBARAM, Srinivas Venkata Ramanuja, Chandler 95249 (US); RAHMAN, Mohammad Mamunur, Gilbert 85249 (US); SHAN, Bohan, Chandler 85226 (US); STACEY, Joshua James, Chandler 85286 (US); TANAKA, Hiroki, Gilbert 85295 (US); VEHONSKY, Jacob Ryan, Chandler 85224 (US)
(74) Representative: HGF

(57) **Abstract**

Package substrates with components included in cavities of glass cores are disclosed. An example apparatus includes: a glass layer having an opening between opposing first and second surfaces of the glass layer; an electronic component within the opening; a dielectric material within the opening between the electronic component and a sidewall of the opening; and a through-glass via including a conductive material that extends through the glass layer.

## Description

### BACKGROUND

Integrated circuit (IC) chips and/or semiconductor dies are routinely connected to larger circuit boards such as motherboards and other types of printed circuit boards (PCBs) via a package substrate. As IC chips and/or dies reduce in size and interconnect densities increase, alternatives to traditional substrate layers are being developed to provide stable transmission of high frequency data signals between different circuitry and/or increased power delivery. One option being pursued is the implementation of package substrates with glass cores.

### BRIEF DESCRIPTION OF THE DRAWINGS

FIG. 1 illustrates an example integrated circuit (IC) package constructed in accordance with teachings disclosed herein.
FIG. 2A illustrates an example glass core assembly that may be implemented within the example package substrate of FIG. 1.
FIG. 2B is an enlarged view corresponding to the dashed box shown in FIG. 2A that represents an example structure of an outer surface of an example through-glass via (TGV) relative to an inner surface of the associated through-hole.
FIG. 2C is an enlarged view corresponding to the dashed box shown in FIG. 2A that represents another example structure of an outer surface of another example TGV relative to an inner surface of the associated through-hole.
FIG. 2D is a top-down cross-sectional view of another example TGV shown in FIG. 2A.
FIG. 2E is a top-down cross-sectional view of another example TGV shown in FIG. 2A.
FIG. 3A illustrates another example glass core assembly that may be implemented within the example package substrate of FIG. 1.
FIG. 3B is an enlarged view corresponding to the dashed box shown in FIG. 3A that represents an example structure of an outer surface of an example through-glass via (TGV) relative to an inner surface of the associated through-hole.
FIG. 3C is an enlarged view corresponding to the dashed box shown in FIG. 3A that represents another example structure of an outer surface of another example TGV relative to an inner surface of the associated through-hole.
FIG. 3D is a top-down cross-sectional view of another example TGV shown in FIG. 3A.
FIG. 3E is a top-down cross-sectional view of another example TGV shown in FIG. 3A.
FIGS. 4-18 illustrate different stages in an example fabrication process to manufacture the example glass core assemblies of FIGS. 2A and/or 3A.
FIG. 19 illustrates another example glass core assembly that may be implemented within the example package substrate of FIG. 1.
FIG. 20 illustrates another example glass core assembly that may be implemented within the example package substrate of FIG. 1.
FIGS. 21-27 illustrate different stages in an example fabrication process to manufacture the example glass core assemblies of FIGS. 19 and/or 20.
FIG. 28 illustrates another example glass core assembly that may be implemented within the example package substrate of FIG. 1.
FIG. 29 illustrates another example glass core assembly that may be implemented within the example package substrate of FIG. 1.
FIGS. 30-36 illustrate different stages in an example fabrication process to manufacture the example glass core assemblies of FIGS. 19 and/or 20.
FIG. 37 illustrates another example glass core assembly that may be implemented within the example package substrate of FIG. 1.
FIG. 38 illustrates another example glass core assembly that may be implemented within the example package substrate of FIG. 1.
FIGS. 39-44 illustrate different stages in an example fabrication process to manufacture the example glass core assemblies of FIGS. 37 and/or 38.
FIG. 45 illustrates an example glass panel that may be processed in accordance with teachings disclosed herein to produce any of the example glass core assemblies of FIGS. 2A, 3A, 19, 20, 28, 29, 37, and/or 38.
FIG. 46 illustrates an example reconstituted panel that includes the example glass panel of FIG. 45 within an example frame.
FIGS. 47A, 47B, 48, and 49 are flowcharts representative of an example method of manufacturing any one of the example glass core assemblies of FIGS. 2A, 3A, 19, 20, 28, 29, 37, and/or 38 that may be implemented in the example IC package 100 of FIG. 1.
FIG. 50 is a top view of a wafer including dies that may be included in an IC package constructed in accordance with teachings disclosed herein.
FIG. 51 is a cross-sectional side view of an IC device that may be included in an IC package constructed in accordance with teachings disclosed herein.
FIG. 52 is a cross-sectional side view of an IC device assembly that may include an IC package constructed in accordance with teachings disclosed herein.
FIG. 53 is a block diagram of an example electrical device that may include an IC package constructed in accordance with teachings disclosed herein.
In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

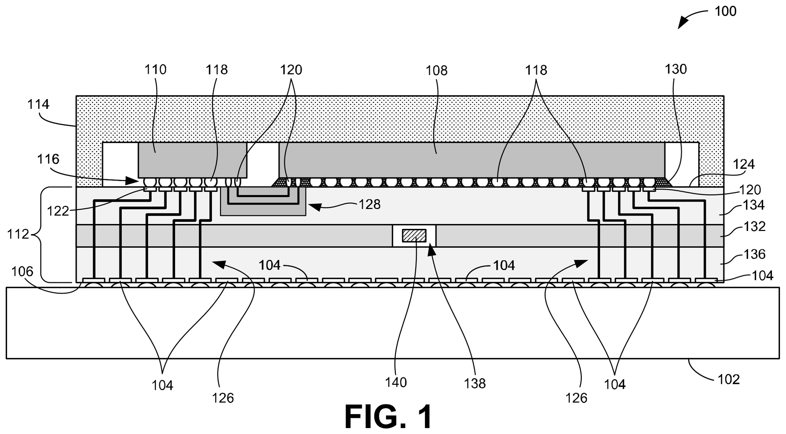

FIG. 1 illustrates an example integrated circuit (IC) package 100 constructed in accordance with teachings disclosed herein. In the illustrated example, the IC package 100 is electrically coupled to an underlying substrate 102 via an array of contacts 104 on a package mounting surface 106 (e.g., a bottom surface, an external surface) of the package. In some examples, the substrate 102 can be implemented by a printed circuit board (PCB) or a package substrate (e.g., the IC package 100 is part of another larger package). In the illustrated example, the contacts 104 are represented as pads or lands. However, in some examples, the IC package 100 may include balls, pins, and/or any other type of contact, in addition to or instead of the pads or lands shown to enable the electrical coupling of the IC package 100 to the substrate 102. In this example, the package 100 includes two semiconductor dies 108, 110 (e.g., silicon dies), sometimes also referred to as chips or chiplets, that are mounted to a package substrate 112 and enclosed by a package lid 114 (e.g., a mold compound, an integrated heat spreader (IHS)). Thus, the package substrate 112 is an example means for supporting a semiconductor die. In some examples, the package lid 114 is omitted, thereby leaving the semiconductor dies 108, 110 exposed or bare.

While the example IC package 100 of FIG. 1 includes two dies 108, 110, in other examples, the IC package 100 may have only one die or more than two dies. In some examples, one of the dies 108, 110 (or a separate die) is embedded in the package substrate 112. The dies 108, 110 can provide any suitable type of functionality (e.g., data processing, memory storage, etc.). In some examples, one or both of the dies 108, 110 are implemented by a die package including multiple dies arranged in a stacked formation. For example, the die 110 can include a stack of Dynamic Random Access Memory (DRAM) die arranged on top of a memory controller die to form a memory die stack.

As shown in the illustrated example, each of the dies 108, 110 is electrically and mechanically coupled to the package substrate 112 via corresponding arrays of interconnects 116. In FIG. 1, the interconnects are shown as bumps. In some examples, the interconnects 116 can include solder joints, micro bumps, combinations of metallic (e.g., copper) pillars and solder, etc. In other examples, the interconnects 116 may include directly bonded or "hybrid bonded" metallic interconnects. In other examples, the interconnects 116 may be any other type of electrical connection in addition to or instead of the bumps shown (e.g., balls, pins, pads, pillars, wire bonding, etc.). The electrical connections between the dies 108, 110 and the package substrate 112 (e.g., the interconnects 116) are sometimes referred to as first level interconnects. By contrast, the electrical connections between the IC package 100 and the substrate 102 (e.g., the contacts 104) are sometimes referred to as second level interconnects. In some examples, one or both of the dies 108, 110 may be stacked on top of one or more other dies and/or an interposer. In such examples, the dies 108, 110 are coupled to the underlying die and/or interposer through a first set of first level interconnects and the underlying die and/or interposer may be connected to the package substrate 112 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 116 of the first level interconnects include two different types of bumps corresponding to core bumps 118 and bridge bumps 120. As used herein, the core bumps 118 are bumps on the dies 108, 110 through which electrical signals pass between the dies 108, 110 and components external to the IC package 100. More particularly, as shown in the illustrated example, when the dies 108, 110 are mounted to the package substrate 112, the core bumps 118 are physically connected and electrically coupled to contact pads 122 on a die mounting surface 124 (e.g., an upper surface, a top surface, etc.) of the package substrate 112. The contact pads 122 on the die mounting surface 124 of the package substrate 112 are electrically coupled to the contacts 104 on the package mounting surface 106 (e.g., the bottom, external surface) of the package substrate 112 (e.g., a surface opposite the die mounting surface 124) via internal interconnects 126 within the package substrate 112. As a result, there is a continuous electrical signal path between the core bumps 118 of the dies 108, 110 and the contacts 104 mounted to the substrate 102 that pass through the contact pads 122 and the interconnects 126 provided therebetween. As shown, the package mounting surface 106 and the die mounting surface 124 define opposing outer surfaces of the package substrate 112. While both surfaces are outer surfaces of the package substrate, the die mounting surface 124 is sometimes referred to herein as an internal or inner surface relative to the overall IC package 100. By contrast, in this example, the package mounting surface 106 is an outer or exterior surface of the IC package 100.

As used herein, the bridge bumps 120 are bumps on the dies 108, 110 through which electrical signals pass between different ones of the dies 108, 110 within the IC package 100. Thus, as shown in the illustrated example, the bridge bumps 120 of the first die 108 are electrically coupled to the bridge bumps 120 of the second die 110 via an interconnect bridge 128 (e.g., a silicon-based interconnect bridge, an interconnect die, an embedded interconnect bridge (EMIB)) embedded in the package substrate 112. As represented in FIG. 1, core bumps 118 are typically larger than bridge bumps 120. In some examples, the interconnect bridge 128 and the associated bridge bumps 120 are omitted.

In some examples, an underfill material 130 is disposed between the dies 108, 110 and the package substrate 112 around and/or between the first level interconnects 116 (e.g., around and/or between the core bumps 118 and/or the bridge bumps 120). In the illustrated example, only the first die 108 is associated with the underfill material 130. However, in other examples, both dies 108, 110 are associated with the underfill material 130. In other examples, the underfill material 130 is omitted. In some examples, the mold compound used for the package lid 114 is used as an underfill material that surrounds the first level interconnects 116.

In some examples, the IC package 100 includes additional passive components, such as surface-mount resistors, capacitors, and/or inductors disposed on the package mounting surface 106 of the package substrate 112 and/or the die mounting surface 124 of the package substrate 112.

In FIG. 1, the substrate 112 of the example IC package 100 includes a glass core 132 (e.g., a glass substrate, a glass layer, etc.) between two separate build-up layers or regions 134, 136 (e.g., a first build-up region 134 and a second build-up region 136, also referred to herein as redistribution layers or regions). In some examples, the glass core 132 includes at least one of: aluminosilicate, borosilicate, alumino-borosilicate, silica, and/or fused silica. In some examples, the glass core 132 includes one or more additives including: aluminum oxide (Al₂O₃), boron trioxide (B₂O₃), magnesia oxide (MgO), calcium oxide (CaO), stoichiometric silicon oxide (SrO), barium oxide (BaO), stannic oxide (SnO₂), nickel alloy (Na₂O), potassium oxide (K₂O), phosphorus trioxide (P₂O₃), zirconium dioxide (ZrO₂), lithium oxide (Li₂O), titanium (Ti), and/or zinc (Zn). In some examples, the glass core 132 includes silicon and oxygen. In some examples, the glass core 132 includes silicon, oxygen and/or one or more of aluminum, boron, magnesium, calcium, barium, tin, sodium, potassium, strontium, phosphorus, zirconium, lithium, titanium, and/or zinc. In some examples, the glass core 132 includes at least 23 percent silicon by weight and at least 26 percent oxygen by weight. In some examples, the glass core is a layer of glass including silicon, oxygen and aluminum. In some examples, the glass core 132 includes at least 23 percent silicon by weight, at least 26 percent oxygen by weight, and at least 5 percent aluminum by weight.

In some examples, the glass core 132 is an amorphous solid glass layer. In some examples, the glass core 132 is a layer of glass that does not include an organic adhesive or an organic material. In some examples, the glass core 132 is a solid layer of glass having a rectangular shape in plan view. In some examples, the glass core 132, as a glass substrate, includes at least one glass layer and does not include epoxy and does not include glass fibers (e.g., does not include an epoxy-based prepreg layer with glass cloth). In some examples, the core 132 corresponds to a single piece of glass that extends the full height/thickness of the core. In other examples, the glass core 132 can be silicon, a dielectric material and/or any other material(s).

In some examples, the glass core 132 has a rectangular shape that is substantially coextensive, in plan view, with the layers above and/or below the core. In some examples, the glass core 132 has a thickness in a range of about 50 micrometers (µm) to about 1.4 millimeters (mm). In some examples, the glass core 132 can be a multi-layer glass substrate (e.g., a coreless substrate), where a glass layer has a thickness in a range of about 25 µm to about 50 µm. In some examples, the glass core 132 can have dimensions of about 10 mm on a side to about 250 mm on a side (e.g., 10 mm by 10 mm to 250 mm by 250 mm). In some examples, the glass core 132 corresponds to a rectangular prism volume with sections (e.g., vias) removed and filled with other materials (e.g., metal). Among other things, glass cores are advantageous over epoxy-based cores because glass is stiffer and, therefore, provides for greater mechanical support or strength for the package substrate. Thus, the glass core 132 is an example means for strengthening the package substrate.

The first and second build-up regions 134, 136 are represented in FIG. 1 as masses/blocks with the internal interconnects 126 extending in straight lines through the build-up regions 134, 136 (and the glass core 132). However, FIG. 1 has been simplified for the sake of clarity and purposes of explanation. In practice, the interconnects are not necessarily straight. More particularly, in some examples, the build-up regions 134, 136 are defined by alternating layers of dielectric material and layers of conductive material (e.g., a metal such as copper). The conductive (metal) layers serve as the basis for the internal interconnects 126 represented, in a simplified form, by straight lines as shown in FIG. 1. In some examples, the metal layers are patterned to define electrical routing or conductive traces that are electrically coupled between different metal layers by conductive (e.g., metal) vias extending through intervening dielectric layers. Further, the electrical routing or traces on either side of the glass core 132 may be electrically coupled by through-glass vias (TGVs) (e.g., copper plated vias) extending through the glass core 132.

Using glass as a starting core material (e.g., the glass core 132 of FIG. 1) has a mechanical benefit, an electrical benefit, and a design flexibility benefit over using traditional organic core materials (e.g., epoxy-based prepreg). Among other things, glass cores are advantageous over epoxy-based cores because glass is stiffer and, therefore, provides for greater mechanical support or strength for the package substrate. Thus, the glass core 132 is an example means for strengthening the package substrate 112. In addition to mechanical benefits, glass cores also provide other advantages including a higher plated through-hole (PTH) density, lower signal losses, and a lower total thickness variation. However, glass cores also present challenges due to the fragile (e.g., brittle) nature of glass, the possibility of defects that can develop into cracks that propagate through the glass, and the associated limitations in the methods that can be used to fabricate and/or process glass cores.

For instance, cavities, holes, and/or openings can be mechanically drilled in an epoxy-based organic core, but such processes are not suitable for glass cores. Instead, cavities, holes, and/or openings in a glass layer are created through a laser induced etching (LIDE) process. Specifically, in a LIDE process, a laser is concentrated on particular regions of a piece of glass (e.g., the glass core 132) to modify the chemical properties of the glass core 132 at those regions. The change in chemical properties increases the etch sensitivity of the glass core 132 at the laser-exposed regions so that those regions can be removed during a subsequent etching process. This etching process exposes the entire glass core 132 to the etch solution. This creates challenges when different cavities, holes, and/or openings are to be added into the glass core 132 at different times. For example, the glass associated with a first opening provided during a first LIDE process may be negatively impacted by exposure to an etch solution associated with a second (subsequent) LIDE process implemented to produce a second (subsequent) opening. Moreover, repeated exposure to an etching solution may affect other portions or features of the glass core 132 regardless of whether the glass associated with the first opening is affected. No such concerns exist in many known fabrication processes for organic-based cores because a first opening can be produced by a first machining (e.g., drilling) process and a second opening can be added at any later point in time by a second machine process without affecting the first opening or other areas of the core.

Examples disclosed herein overcome one or more of the above challenges based on a process flow in which multiple different types of cavities, holes, and/or openings are produced in the glass core during a single LIDE process. More particularly, in some examples, the different types of openings include through-holes for the TGVs associated with the interconnects 126 as well as at least one larger cavity 138 that is of sufficient size to house some other electronic component 140 disposed therein. The electronic component 140 can be any suitable electronic component such as a coaxial magnetic inductor loop (CMIL), a deep trench capacitor (DTC), another semiconductor device (e.g., a semiconductor die), etc. In the example shown in FIG. 1, the electronic component 140 is contained entirely within the cavity 138. However, in some examples, at least some of the electronic component 140 extends beyond the cavity 138. In some examples, more than one electronic component 140 (whether of the same type or of different types) can be positioned within a given cavity 138 (e.g., in the X, Y, and/or Z directions). Additionally or alternatively, the glass core 132 can include more than one cavity 138, with each such cavity including one or more electronic component(s) 140. Fabricating through-holes for TGVs in a glass core 132 at the same time as (e.g., concurrently with) a larger cavity 138 avoids concerns of multiple etching processes having a negative impact on the glass core 132 (e.g., on the structural integrity of the glass core 132 and/or on one or more structural features of the glass core 132).

Further, examples disclosed herein ensure the features and/or structures to be provided in the different types of openings can be fabricated without affecting one another. For instance, in some examples, after creating the through-holes and the cavity 138, the cavity 138 is subsequently filled with a dielectric material before the through-holes are filled with a conductive material (e.g., metal, such as copper) to define the TGVs. By first filling the cavity 138 with a dielectric material, the plating process to add conductive material to produce the TGVs does not result in any conductive material entering the cavity 138. Further, in some examples, the dielectric material within the cavity can be processed using methods not suitable for glass. For instance, a machining (e.g., drilling) process can be performed to remove portions of the dielectric material to make room for the electronic component(s) 140 in a manner similar to known processes that involve organic-based cores.

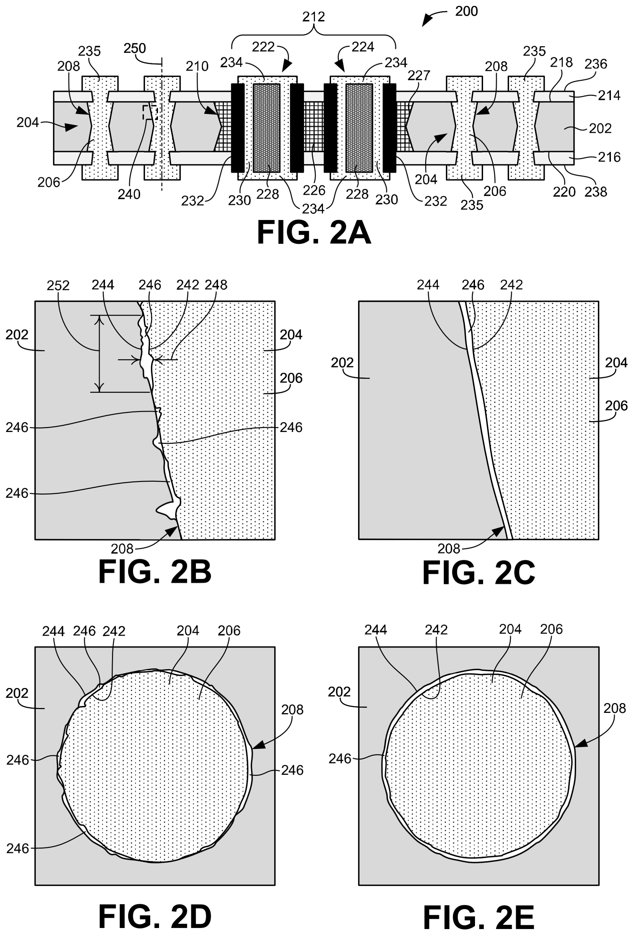

FIG. 2A illustrates an example glass core assembly 200 that may be implemented within the example package substrate 112 of FIG. 1. In the illustrated example of FIG. 2, the glass core assembly 200 includes the glass core 202 that may correspond to the glass core 132 described above in connection with FIG. 1. Thus, the description of the glass core 132 above in connection with FIG. 1 applies similarly to the glass core 202 of FIG. 2. As shown in FIG. 2A, the glass core 202 includes a plurality of through-glass vias (TGVs) 204 defined by a first conductive material 206 that substantially fills associated through-holes 208 (e.g., holes, cavities, openings, etc.) extending through the glass core 202. As used herein, "substantially fills" or "substantially filling" means filled to at least 95%. In some examples, the first conductive material 206 includes any suitable metal such as copper. In some examples, the TGVs 204 of FIG. 2 correspond to portions of the internal interconnects 126 extending through the package substrate 112 of FIG. 1.

As shown in the illustrated example, the glass core 202 includes a cavity 210 that corresponds to the cavity 138 of FIG. 1. Thus, as shown in FIG. 2A, an electronic component 212 (corresponding to the electronic component 140 of FIG. 1) is disposed within the cavity 210. In this example, the electronic component 212 is a coaxial magnetic inductor loop (CMIL). For purposes of explanation, the electronic component 212 will be referred to as the CMIL 212 hereafter. Nonetheless, one or more additional and/or other type(s) of electronic component(s) may be used. As shown, the example CMIL 212 extends through the glass core assembly 200, including through first and second buffer layers 214, 216 (e.g., adhesive layers, dielectric layers) on respective first and second surfaces 218, 220 of the glass core 202. Thus, in this example, the CMIL 212 extends through and beyond the cavity 210 (e.g., above and/or below the first and second surfaces 218, 220). In some examples, the buffers layers 214, 216 are composed of a dielectric material. More particularly, in some examples, the buffer layers 214, 216 include an organic laminate dielectric (e.g., an epoxy-based build-up dielectric).

In the illustrated example of FIG. 2A, the CMIL 212 includes first and second portions 222, 224 defined by two plated through-holes within a dielectric material 226 within the cavity 210. More particularly, as shown in FIG. 2A, the dielectric material 226 substantially fills the gap(s) within the cavity 210 that are not occupied by the structure of the CMIL 212. In some examples, the dielectric material 226 fills the space between the CMIL 212 and a sidewall 227 (e.g., an inward facing surface, a wall, etc.) of the cavity 210 to separate the CMIL 212 from the glass core 202. Further, in some such examples, the dielectric material 226 fills the space between the different portions 222, 224 of the CMIL 212.

In the illustrated example, each of the first and second portions 222, 224 of the CMIL 212 includes a non-magnetic plug 228 (e.g., non-magnetic core) defining a central region of each portion 222, 224 that is surrounded by a second conductive material 230 that is itself surrounded by a magnetic material 232 (e.g., magnetic lining). That is, in some examples, the magnetic material 232 defines a magnetic exterior to each portion 222, 224 of the CMIL 212 with the conductive material 230 defining a conductive core for each portion 222, 224 of the CMIL 212. In some examples, the portions of the non-magnetic plug 228, the conductive material 230, and the magnetic material 232 of the CMIL 212 have a generally cylindrical shape. In some examples, the non-magnetic plug 228 includes a dielectric material (e.g., epoxy). In some examples, the non-magnetic plug 228 is omitted and the central region of each portion 222, 224 is filled by a solid mass of the second conductive material 230. That is, in some examples, the second conductive material 230 extends continuously across the space inside the magnetic material 232. In some examples, the second conductive material 230 includes the same metal as the first conductive material 206 in the TGVs 204 (e.g., copper). In other examples, the second conductive material 230 can include any other suitable conductive material (e.g., metal). In some examples, the magnetic material 232 includes any suitable material with magnetic properties (e.g., iron, alloys containing iron (e.g., silicon steel), a ferrite material (e.g., nickel zinc ferrite (e.g., NiₐZn₍₁₋ₐ₎Fe2O₄), a manganese ferrite (e.g., MnₐZn₍₁₋ₐ₎Fe₂O₄), a cobalt ferrite (e.g., CoFe₂O₄, CoO·Fe₂O₃), etc.), other ferromagnetic particles or elements, etc.).

In the illustrated example of FIG. 2A, the first and second portions 222, 224 of the CMIL 212 are capped at each end by respective conductive pads 234 (e.g., contact pads). In some examples, the conductive pads 234 include the same material as the second conductive material 230 (e.g., copper) that extends along the axial lengths of the two portions 222, 224 of the CMIL 212. In some examples, the conductive pads 234 associated with the portions 222, 224 of the CMIL 212 are in the same metal layer as additional conductive pads 235 electrically coupled to the TGVs 204.

In FIG. 2A, the first and second buffer layers 214, 216 are represented as different materials from the dielectric material 226 that fills the gap(s) in the cavity 210 surrounding the CMIL 212. More particularly, as noted above, in some examples, the first and second buffer layers 214, 216 include an organic laminate dielectric (e.g., an epoxy-based build-up dielectric), whereas the dielectric material 226 includes a liquid dispensable dielectric. In other examples, the first and second buffer layers 214, 216 include the same material as the dielectric material 226 within the cavity 210.

As noted above, in this example, the first and second buffer layers 214, 216 are on the opposing first and second surfaces 218, 229 of the glass core 202. Thus, in this example, the first and second buffer layers 214, 216 define first and second outer surfaces 236, 238 of the overall glass core assembly 200. However, in some examples, the first and second buffer layers 214, 216 shown in FIG. 2A may be omitted and/or correspond to a first layer of build-up regions (e.g., the build-up regions 134, 136 of FIG. 1) on either side of the glass core assembly 200. In such examples, the first and second surfaces of the glass core 202 define the first and second outer surfaces 236, 238 of the overall glass core assembly 200.

FIG. 2B is an enlarged view corresponding to the dashed box 240 shown in FIG. 2A that represents an example structure of an outer surface 242 (e.g., outward facing surface) of the first conductive material 206 defining the TGVs 204 relative to an inner surface 244 (e.g., an inward facing surface, a wall, sidewall, etc.) of the through-hole 208. FIG. 2C is an enlarged view corresponding to the dashed box 240 shown in FIG. 2A that represents another example structure of the outer surface 242 of the first conductive material 206 facing toward the inner surface 244 of the through-hole 208. In the example of FIG. 2B, a plurality of open spaces 246 (e.g., gaps, voids, etc.) are defined between the facing surfaces 242, 244. That is, the open spaces 246 separate at least portions of the outer surface 242 of the conductive material 206 and the inner surface 244 of the through-hole 208. In some examples, the open spaces 246 are empty and/or devoid of solid material. In some instances, the open spaces 246 are defined by notches, crevices, and/or defects in one or both of the facing surfaces 242, 244 of the TGV 204 and the glass core 202. Additionally or alternatively, in some examples, the facing surfaces 242, 244 may be relatively smooth (e.g., substantially free of notches, crevices, and/or defects) but slightly spaced apart to define a single gap and/or open space 246 therebetween. Such a gap and/or open space 246 may be relatively long as represented in the illustrated example of FIG. 2C when compared with the shorter open spaced 246 shown in FIG. 2B. In other examples, the gap(s) and/or open space(s) 246 can be any other size.

The open space(s) 246 between the glass core 202 and the TGV 204 can differ in size. For instance, in some examples, the open spaces have a width 248 measured in a direction radial to (e.g., perpendicular to) a longitudinal axis 250 (shown in FIG. 2A) of the through-hole 208 (e.g., a longitudinal axis of the TGV 204) up to approximately 250 nanometers (nm) but sometimes significantly less (e.g., approximately 200 nm or less, approximately 150 nm or less, approximately 100 nm or less, approximately 50 nm or less, approximately 25 nm or less, etc.). By contrast, as shown in FIG. 2B, the example open spaces 246 have a length 252 measured in a direction parallel to the longitudinal axis 250 that can be significantly greater than the width 248 (e.g., at least twice the width 248, at least 3 times the width 248, at least 5 times the width 248, at least 10 times the width 248, etc.). In some examples, the length 252 of a given open space 246 extends an appreciable distance (e.g., at least 5%, at least 10%, at least 25%, at least 50%, at least 75%, at least 90%, etc.) of the full length of the through-hole 208 or TGV 204. In some examples, a single open space 246 can extend a full length of the through-hole 208. In other examples, multiple open spaces 246 (which may or may not be in communication) are present.

In some examples, the open space(s) 246 not only extend longitudinally partly and/or completely along the length of the through-hole 208, but the open space(s) 246 also extend partly and/or completely circumferentially along the inner surface 244 of the through-hole 208 (e.g., along a cross-sectional perimeter of the first conductive material 206) as shown in FIGS. 2D and 2E. Specifically, FIG. 2D is a top-down cross-sectional view of an example TGV 204 shown in FIG. 2A (e.g., the same TGV 204 as in FIG. 2B, the same TGV 204 as in FIG. 2C, or a different TGV). FIG. 2E is a top-down cross-sectional view of another example TGV 204 shown in FIG. 2A (e.g., the same TGV 204 as in FIG. 2B, the same TGV 204 as in FIG. 2C, or a different TGV). The example of FIG. 2D differs from the example of FIG. 2E in that FIG. 2D shows multiple open spaces 246 extending different circumferential lengths around the TGV 204, whereas FIG. 2E shows a single open space 246 extending the entire circumference around the TGV 204. More than one open space 246 may be in the same circumferential plane. Thus, as shown, the open space(s) 246 can extend any suitable circumferential distances around the TGV 204 (e.g., at least 5%, at least 10%, at least 25%, at least 50%, at least 75%, at least 90%, etc.). While there may be one or more open space(s) 246 between the conductive material 206 of the TGVs 204 and the inner surface 244 (e.g., sidewall) of the associated through-hole 208, in some examples, the dielectric material 226 in the cavity 210 is in direct contact (e.g., abuts) the sidewall 227 of the cavity 210 everywhere and/or in most areas.

In some examples, the open space(s) 246 are created based on the way in which the first conductive material 206 is plated within the through-hole 208 to produce the TGV 204. Known TGVs are often fabricated by first depositing a seed layer on the surface of the glass core (e.g., along the inner surface of the through-hole 208) using an electroless plating process. Thereafter, the bulk of the first conductive material 206 is then deposited onto the seed layer using an electrolytic plating process with the seed layer serving as an electrode. The implementation of the seed layer facilitates relative strong adhesion between the conductive material and the inner wall of the through-hole that is being plated. Unlike this known approach, in some examples, the TGVs 204 are deposited using a bottom-up plating process without a seed layer. That is, a conductive material is positioned at the base or bottom of the through-holes 208 to act as an electrode in an electrolytic plating process through which the first conductive material 206 is deposited until it builds up through the full length (or substantially the full length (e.g., at least 90%)) of the through-hole 208.

Inasmuch as there is no seed layer along the walls (e.g., the inner surface 244) of the through-hole 208 in such examples, the conductive material onto which the first conductive material 206 will be plated is the base underlying electrode and the portions of the first conductive material 206 progressively deposited thereon during the plating process. As a result, no strong adhesion develops between the first conductive material 206 and the glass core 202, which results in the one or more open space(s) 246 as described above. The lack of adhesion between the first conductive material 206 and the glass core 202 and the associated open space(s) 246 therebetween is advantageous because it reduces stress arising from a mismatch in the coefficient of thermal expansion (CTE) of the two different materials. That is, the open space(s) 246 can provide some space for the first conductive material 206 to expand and/or contract radially without significantly impacting the glass core 202. Further, the relatively low adhesion and associated open space(s) 246 enable the first conductive material 206 to expand longitudinally to allow for longitudinal shifts of the material relative to the glass core 202 without creating undue stress on the glass core 202. As a result, examples disclosed herein reduce stress in the glass core 202, thereby reducing the onset of cracks and/or other failures known to occur in known glass core applications.

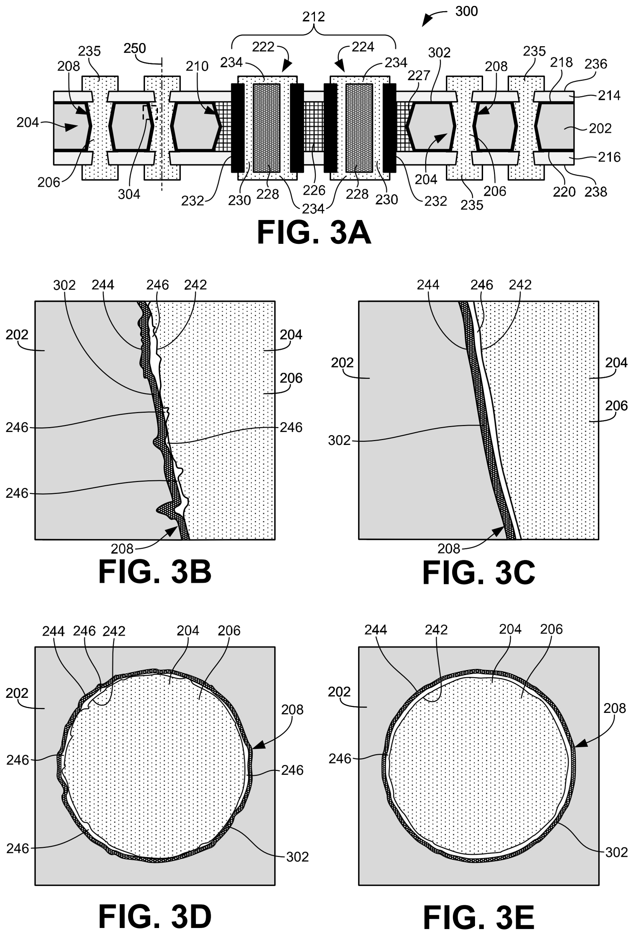

FIG. 3A illustrates another example glass core assembly 300 that may be implemented within the example package substrate 112 of FIG. 1. The example glass core assembly 300 of FIG. 3A is substantially the same as the example glass core assembly 200 of FIG. 2A except as noted below and/or otherwise made clear from the context. Accordingly, the features shown in FIG. 3A that are the same or similar to corresponding features in FIG. 2A are identified by the same reference numbers. Further, the description of such features described above in connection with FIG. 2A applies similarly with respect to the corresponding features in FIG. 3A. Specifically, the example glass core assembly 300 includes the glass core 202 that includes the TGVs 204 extending therethrough as well as the cavity 210 within which is disposed the CMIL 212.

The example of FIG. 3A differs from the example of FIG. 2A based on the inclusion of a thin film dielectric 302 (e.g., dielectric layer) that coats the exterior surfaces of the glass core 202. That is, as shown in FIG. 3A, the thin film dielectric 302 extends along the opposing first and second surfaces 218, 220 of the glass core 202 and along the sidewalls of the through-holes 208 and the cavity 210. In some examples, the thin film dielectric 302 includes a same dielectric material used in the first and second buffer layers 214, 216 and/or the same dielectric material used in the dielectric material 226 that fills the cavity 210. In other examples, the thin film dielectric 302 is different from the material used in the first and second buffer layers 214, 216 and different from the dielectric material 226 that fills the cavity 210. More particularly, in some examples, the think film dielectric 302 includes at least one of silicon nitride, silicon oxide, silicon carbide, carbon doped oxide (CDO), polyimide, parylene, and/or any other suitable dielectric material. In some examples, the thin film dielectric 302 is referred to as a healing layer because it "heals" the underlying glass by filling in notches, cracks, and/or crevices on the surface of the glass core, thereby reducing the negative impacts of such.

FIGS. 3B and 3C are enlarged views corresponding to the dashed box 304 shown in FIG. 3A that represents different example structures of the outer surface 242 of the first conductive material 206 facing toward the inner surface 244 of the through-hole 208. FIGS. 3E and 3F are top-down cross-sectional views of different example TGVs 204 shown in FIG. 3A. FIGS. 3B-3E are substantially the same as FIGS. 2B- 2E except as noted below and/or otherwise made clear from the context. More particularly, FIGS. 3B-3E show the thin film dielectric 302 coating (e.g., in contact with, abutting) the inner surface of the through-hole 208 of the glass core 202. As shown, in these examples, there are still open space(s) 246 between the inner surface 244 of the through-hole 208 and the outer surface 242 of the first conductive material 206 (e.g., the TGV 204). However, in these examples, the thin film dielectric 302 is positioned between the glass core 202 and the open space(s) 246. While there may be open space(s) 246 between the conductive material 206 of the TGVs 204 and the inner surface 244 of the associated through-hole 208, in some examples, the dielectric material 226 in the cavity 210 is in direct contact (e.g., abuts) the thin film dielectric 302 that abuts the sidewall 227 of the cavity 210.

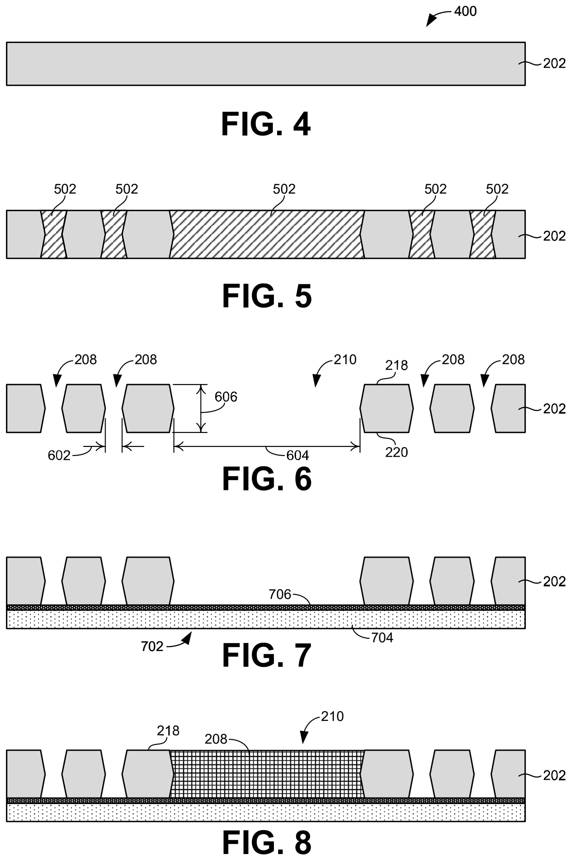

FIGS. 4-18 illustrate different stages in an example fabrication process to manufacture the example glass core assembly 200 of FIG. 2A and/or the example glass core assembly 300 of FIG. 3A. FIG. 4 represents a glass panel 400 corresponding to the initial state of the glass core 202. In some examples, the glass panel 400 is fabricated to a thickness corresponding to the final thickness of the glass core 202. However, in some examples, the glass panel 400 is initially slightly larger than the final thickness of the glass core 202 to enable some amount of the glass to be removed during subsequent polishing or planarization processes as discussed further below.

FIG. 5 represents the stage of fabrication following exposure of the glass core 202 to a laser as part of a laser induced deep etching (LIDE) process. The laser is concentrated on defined regions 502 of the glass core 202 to modify the optical and/or chemical properties of the glass core 202 at those regions 502. FIG. 6 represents the stage of fabrication following a chemical etch process to remove the material in the modified regions 502 of the glass core 202 shown in FIG. 4 to define the through-holes 208 for the TGVs 204 and the cavity 210 associated with the location of the CMIL 212. In this example, both the through-holes 208 and the cavity 210 have a cross-sectional profile generally corresponding to an hourglass shape with the width (e.g., diameter) of the openings being narrower near a midpoint of the openings between the opposing first and second surfaces 218, 220 of the glass core 202. In other examples, one or more of the through-holes 208 and/or the cavity 210 may have a different cross-sectional shape. For instance, in some examples, one or more of the through-holes 208 and/or the cavity 210 may have a generally conical or tapered shape with the width (e.g., diameter) being smallest at one of the two surfaces 218, 220 of the glass core 202 and the width (e.g., diameter) being largest at the opposite surface 218, 220. In other examples, the width (e.g., diameter) of one or more of the through-holes 208 and/or the cavity 210 is approximately consistent along a full length of the openings between the opposing surfaces 218, 220 of the glass core 202.

As shown in FIG. 6, the through-holes 208 have a first width 602 that is smaller than a second width 604 of the cavity 210. In some examples, the second width 604 is significantly greater than the first width 602 (e.g., at least twice as great, at least three times as great, at least five times as great, at least ten times as great, etc.). Although different in width, the through-holes 208 and the cavity 210 have a same height 606 (e.g., length) defined by a thickness of the glass core (e.g., the distance between the first and second surfaces 218, 220). Thus, in the illustrated example, the through-holes 208 have a first height-to-width aspect ratio that is larger than a second height-to-width aspect ratio of the cavity.

In some examples, the fabrication process following the stage represented in FIG. 6 (and before FIG. 7) includes depositing the thin film dielectric 302 to all exterior (e.g., exposed) surfaces of the glass core 202 as discussed above in connection with FIGS. 3A-3E. In some such examples, the thin film dielectric 302 is deposited using a conformal coating process (e.g., chemical vapor deposition (CVD), atomic layer deposition (ALD), etc.). In other examples, the thin film dielectric 302 is deposited using a directional deposition process (e.g., physical vapor deposition (PVD), etc.).

FIG. 7 represents the stage of fabrication following the glass core 202 being attached to a conductive carrier 702. In this example, the conductive carrier includes a conductive layer 704 (e.g., a copper layer) and a release layer 706 (e.g., an adhesive dielectric layer). FIG. 8 represents the stage of fabrication after the cavity 210 in the glass core 202 is filled with the dielectric material 226. In some examples, the dielectric material 226 is dispensed as a liquid or paste (e.g., a liquid dispensable dielectric) into the opening and subsequently cured. In some examples, any excess of the dielectric material 226 that extends beyond the first surface 218 of the glass core 202 is removed by a polishing (e.g., a chemical mechanical planarization (CMP)) process. In some examples, this polishing process slightly thins the glass core 202.

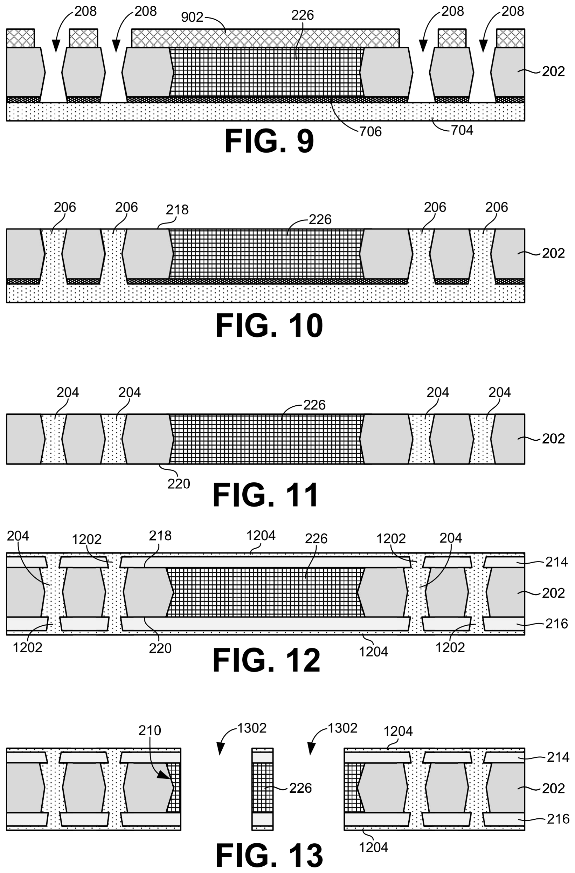

FIG. 9 represents the stage of fabrication following the application of a mask 902 (e.g., via photolithography) to cover the assembly except for the through-holes 208 of the glass core. Further, the stage of fabrication represented in FIG. 9 is after an etching process (e.g., a plasma etch, a dry etch) to remove portions of the release layer 706 exposed within the through-holes 208 of the glass core 202, thereby exposing the underlying conductive layer 704. The mask 902 protects the dielectric material 226 during the etching process.

FIG. 10 represents the stage of fabrication following the removal (e.g., stripping) of the mask 902 and subsequent plating of the conductive material 206 (e.g., copper) within the through-holes 208 to define the TGVs 204 extending through the glass core 202. In this example, the TGVs 204 are plated up from the exposed portions of the conductive layer 704 (e.g., bottom-up plating). As such, in this example, there is no seed layer deposited along the walls of the through-holes 208 prior to the plating process. However, in other examples, a seed layer may be used to facilitate the plating of the TGVs 204. The stage of fabrication represented in FIG. 10 is also after a subsequent polishing process (e.g., a CMP process) to remove excess copper that extends above the first surface 218 of the glass core 202. Thus, in some examples, the outer surfaces (e.g., ends) of both the dielectric material 226 and the TGVs 204 are substantially flush and/or substantially parallel with the first surface 218. As used herein, two surfaces are substantially flush when there is no more than 100 nm of offset between them. Further, as used herein, two surfaces are substantially parallel when they are within 3 degrees of exactly parallel.

FIG. 11 represents the stage of fabrication following the removal of the conductive carrier 702, including both the conductive layer 704 and the release layer 706. In some examples, the second surface 220 of the glass core 202 undergoes a polishing process (e.g., a CMP process) to make the both the dielectric material 226 and the TGVs 204 substantially flush with the second surface 220. In some examples, the assembly also undergoes a cleaning process to remove any residue materials.

FIG. 12 represents the stage of fabrication following the application (e.g., lamination) of the first and second buffer layers 214, 216 on the respective first and second surfaces 218, 220 of the glass core 202 as well as across the outer surfaces of the dielectric material 226 within the cavity 210. FIG. 12 also represents the result of adding conductive vias 1202 through the buffer layers 214, 216 to electrically couple the underlying TGVs 204 to outer layers of conductive material 1204. More particularly, holes (e.g., vias) are drilled through the buffer layers 214, 216 to expose the ends of the TGVs 204 and then the holes are filled to define the material of the conductive vias 1206 and to produce the outer layers of conductive material 1204. In some examples, the outer layers of conductive material 1204 serves as the basis for the subsequent development of the conductive pads 235 for the TGVs 204 as discussed above in connection with FIG. 2A.

FIG. 13 represents the stage of fabrication following the drilling of holes 1302 through the outer layers of conductive material 1204, the buffer layers 214, 216, and the dielectric material 226. Thus, the holes 1302 in FIG. 13 extend through the cavity 210 within the glass core 202, and the outer layers of conductive material 1204. In this example, the holes 1302 define the outer extent of the first and second portions 222, 224 of the CMIL 212 shown in FIG. 2A. Unlike the through-holes 208 and the cavity 210 in the glass core 202 that are created through a LIDE process, the holes 1302 through the dielectric material 226 can be directly machined (e.g., drilled). Thus, in some examples, the holes 1302 are round holes with opposing sidewalls that are straight (e.g., substantially parallel along a full length of the round holes 1302). By contrast, as shown in the illustrated example, the sidewalls of the cavity 210 are not straight (e.g., non-parallel along the full length of the cavity walls).

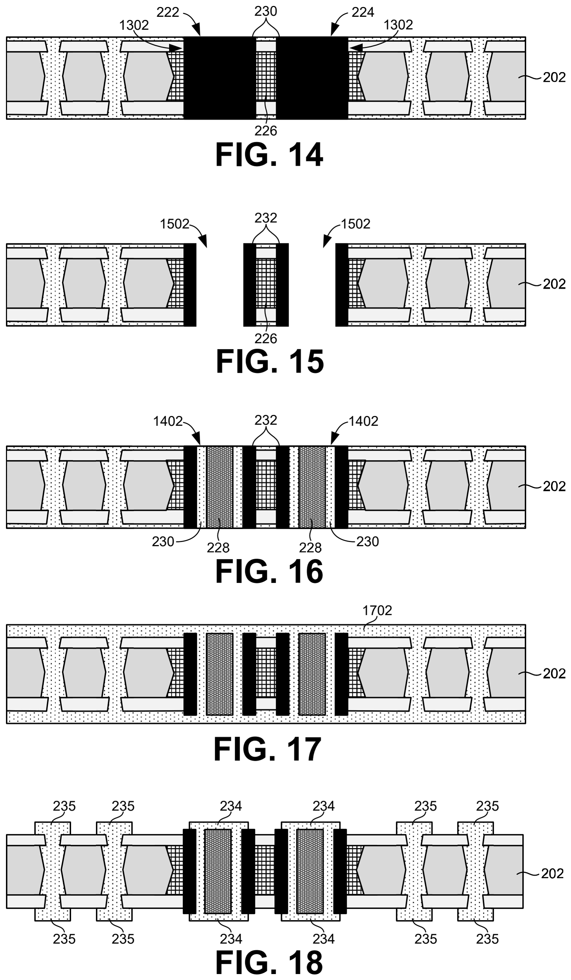

FIG. 14 represents the stage of fabrication following the filling of the holes 1302 with the magnetic material 232 used in the CMIL 212. In some examples, the magnetic material 232 is deposited within the holes 1302 as a paste or resin that is subsequently cured. Thereafter, a grinding and/or polishing process (e.g., a CMP process) may be employed on both sides of the assembly to remove excess material.

FIG. 15 represents the stage of fabrication following the drilling of inner through-holes 1402 through the middle of the different portions of the magnetic material 232.

FIG. 16 represents the stage of fabrication following the deposition (e.g., electrolytic plating) of the conductive material 230 onto the walls of the inner through-holes 1402 (e.g., the inner walls of the magnetic material 232) are plated with the conductive material 230. In some examples, this is accomplished through a bottom-up plating process. In other examples, this is accomplished through direct plating onto the magnetic material 232 and/or a seed layer on the magnetic material 232. As shown in FIG. 16, the remaining central region of the inner through-holes 1402 (inside of the conductive material 230) is filled the non-magnetic plug 228. In some examples, the non-magnetic plug 228 is deposited within the central region of the conductive material 230 as a paste or resin that is subsequently cured. Thereafter, a grinding and/or polishing process (e.g., a CMP process) may be employed on both sides of the assembly to remove excess material.

FIG. 17 represents the stage of fabrication following the deposition (e.g., plating) of additional conductive material 1702 onto the outer layers of conductive material 1204 added at the stage represented in FIG. 12. AS shown in FIG. 17, the additional conductive material 1702 extends across the CMIL 212.

FIG. 18 represents the stage of fabrication following the selective removal (e.g., via photolithography) of portions of the additional conductive material 1702 (as well as the previously deposited outer layers of conductive material 1204) to provide the conductive pads 235 associated with the TGVs 204 and the conductive pads 234 that cap the ends of the first and second portions 222, 224 of the CMIL 212. The structure of the example glass core assembly shown in FIG. 18 corresponds to the structure of the example glass core assembly 200 shown in FIG. 2A and, thus, represents the completion of the fabrication process.

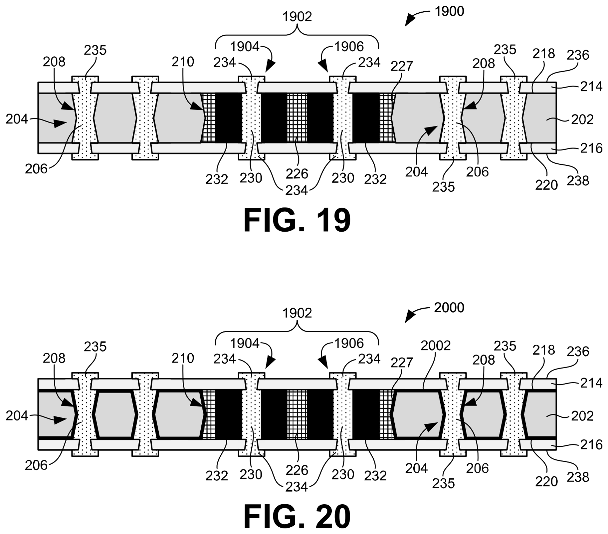

FIG. 19 illustrates another example glass core assembly 1900 that may be implemented within the example package substrate 112 of FIG. 1. The example glass core assembly 1900 of FIG. 19 is substantially the same as the example glass core assembly 200 of FIGS. 2A-2E except as noted below and/or otherwise made clear from the context. Accordingly, the features shown in FIG. 19 that are the same or similar to corresponding features in FIGS. 2A-2E (and associated FIGS. 4-18) are identified by the same reference numbers. Further, the description of such features described above in connection with FIGS. 2A-2E (and associated FIGS. 4-18) applies similarly with respect to the corresponding features in FIG. 19.

The example of FIG. 19 differs from the example of FIG. 2A in the construction of the example CMIL 1902 (e.g., an electronic component) embedded within the cavity 210 in the glass core 202. Specifically, in FIG. 2A, the central regions of the two portions 222, 224 of the CMIL 212 are defined by the non-magnetic plug 228. By contrast, in the illustrated example of FIG. 19, there is no non-magnetic plug in the first and second portions 1904, 1906 of the CMIL 1902. Instead, the central region of the two portions 1904, 1906 are defined by the conductive material 230 (e.g., copper) that fills the entire space inside of the magnetic material 232. That is, the conductive material 230 within the first and second portions 1904, 1906 is a solid mass that extends continuously from the inner surface of the magnetic material 232 to the center (e.g., central axis) of longitudinal lengths of the portions 1904, 1906. In other words, in the illustrated example of FIG. 19, each portion 1904, 1906 includes a solid metal core that extends continuously across a cross-section of the metal core.

Another difference between the example of FIG. 19 relative to the example of FIG. 2A is the thickness of the magnetic material 232. That is, as shown in the illustrated example, the magnetic material 232 is thicker in the illustrated example of FIG. 19 than in the illustrated example of FIG. 2A. In other examples (based on either FIG. 2A or FIG. 19), the thickness of the magnetic material 232 can be different from what is shown. Additionally, in the illustrated example of FIG. 19, the upper and lower ends of the magnetic material 232 are coextensive with the dielectric material 226 within the cavity 210. That is, in this example, the ends (e.g., an outer surface) of the magnetic material 232 (as well as the dielectric material 226) are substantially flush with the opposing first and second surfaces 218, 220 (e.g., outer surfaces) of the glass core 202. This is different from the example in FIG. 2A where the magnetic material extends beyond the dielectric material 226 and the opposing surfaces of the glass core 202.

FIG. 20 illustrates another example glass core assembly 2000 that may be implemented within the example package substrate 112 of FIG. 1. The example glass core assembly 2000 of FIG. 20 is substantially the same as the example glass core assembly 1900 of FIG. 19 except as noted below and/or otherwise made clear from the context. Accordingly, the features shown in FIG. 20 that are the same or similar to corresponding features in FIG. 19 are identified by the same reference numbers. Further, the description of such features described above in connection with FIG. 19 applies similarly with respect to the corresponding features in FIG. 20.

The example of FIG. 20 differs from the example of FIG. 19 based on the inclusion of a thin film dielectric 2002 (e.g., dielectric layer) that coats the exterior surfaces of the glass core 202. In some examples, the thin film dielectric 2002 is substantially the same as the thin film dielectric 302 of FIG. 3A. Accordingly, the description of the thin film dielectric 302 described above in connection with FIG. 3A (and associated FIGS. 3B-3E) applies similarly with respect to the thin film dielectric 2002 of FIG. 20.

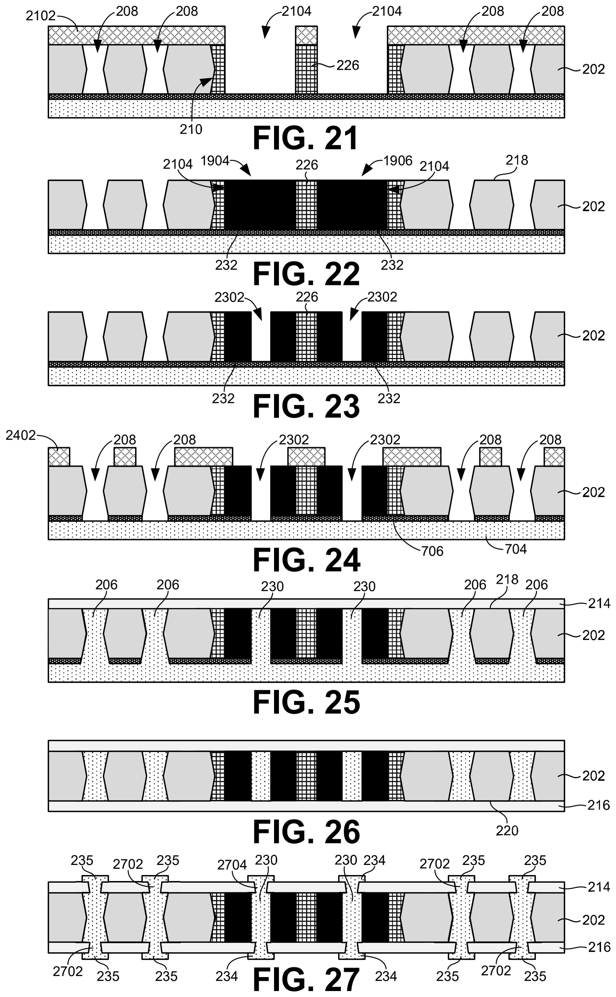

The process to fabricate the example glass core assemblies 1900, 2000 of FIGS. 19 and 20 can follow the same or similar processes detailed above in connection with the different stages of fabrication represented by FIGS. 4-8 discussed above in connection with the example glass core assemblies 200, 300 of FIGS. 2A and 3A. However, after the stage of fabrication represented in FIG. 8, the subsequent processes may diverge. FIGS. 21-27 illustrate different stages in the subsequent process flow to manufacture the example glass core assemblies 1900, 2000 of FIGS. 19 and 20.

FIG. 21 represents the stage of fabrication following the application of a mask 2102 (e.g., via photolithography) to cover the assembly, including the through-holes 208 and the dielectric material 226 within the cavity 210 of the glass core 202. Further, the stage of fabrication represented in FIG. 9 is after the drilling of holes 2104 through the mask 2102 and the dielectric material 226. In this example, the holes 2104 define the outer extent of the first and second portions 1904, 1906 of the CMIL 1902 shown in FIG.19. Thus, in this example, the holes 2104 are comparable to the holes 1302 provided in FIG. 13. Thus, the description of the holes 1302 of FIG. 13 applies similarly to the holes 2104 of FIG. 21.

FIG. 22 represents the stage of fabrication following the filling of the holes 2104 with the magnetic material 232 used in the CMIL 212. In some examples, the magnetic material 232 is deposited within the holes 1302 as a paste or resin that is subsequently cured. Thereafter, a grinding and/or polishing process (e.g., a CMP process) may be employed on both sides of the assembly to remove excess material. In some examples, the grinding and/or polishing process is also used to remove the mask 2102 as represented in FIG. 22. Alternatively, in some examples, the mask 2102 can be removed via stripping and then a subsequent polishing and/or grinding process can be implemented to remove any residue and ensure the outer surface of the magnetic material 232 is substantially flush with the first surface 218 of the glass core 202.

FIG. 23 represents the stage of fabrication following the drilling of inner through-holes 2302 through the middle of the different portions of the magnetic material 232.

FIG. 24 represents the stage of fabrication following the application of another mask 2402 (e.g., via photolithography) to cover the assembly except for the through-holes 208 in the glass core 202 and the inner through-holes 2302 in the magnetic material 232. Further, the stage of fabrication represented in FIG. 9 is after an etching process (e.g., a plasma etch, a dry etch) to remove portions of the release layer 706 exposed within the through-holes 208, 2302, thereby exposing the underlying conductive layer 704. Similar to what is described above in connection with FIG. 9, the mask 2402 protects the dielectric material 226 during the etching process.

FIG. 25 represents the stage of fabrication following the removal (e.g., stripping) of the mask 2402 and subsequent plating of the conductive material 206, 230 (e.g., copper) within the through-holes 208, 2302 to define the TGVs 204 extending through the glass core 202 and to define the central regions of the different portions 1904, 1906 of the CMIL 1902. In this example, the through-holes 208, 2302 are plated up from the exposed portions of the conductive layer 704 (e.g., bottom-up plating). As such, in this example, there is no seed layer deposited along the walls of the through-holes 208, 2302 prior to the plating process. As a result, open space(s) 246 (e.g., gap(s), void(s), etc.) may be positioned between the conductive material 206 of the TGVs 204 and the sidewall (e.g., inner surface 244) of the through-holes 208 as discussed above in connection with FIGS. 2B-2E. Further, inasmuch as the inner through-holes 2302 are plated concurrently with the through-holes 208 during the same bottom-up plating process (e.g., with no seed layer), similar open spaces 246 (e.g., gaps, voids, etc.) may be positioned between the conductive material 230 in the inner through-holes 2302 and a sidewall of the inner through-holes 2302. In other examples, a seed layer may be used to facilitate the plating of the through-holes 208, 2302.

The stage of fabrication represented in FIG. 25 is also after a subsequent polishing process (e.g., a CMP process) to remove excess copper that extends above the first surface 218 of the glass core 202. Thus, in some examples, both the dielectric material 226 and the TGVs 204 are substantially flush with the first surface 218. Further, FIG. 25 represents the stage of fabrication following the application (e.g., lamination) of the first buffer layer 214 on the first surface 218 of the glass core 202 as well as across the outer surface of the dielectric material 226 and the upper end of the CMIL 1902.

FIG. 26 represents the stage of fabrication following the removal of the conductive carrier 702, including both the conductive layer 704 and the release layer 706. In some examples, the second surface 220 of the glass core 202 undergoes a polishing process (e.g., a CMP process) to make the both the dielectric material 226 and the TGVs 204 substantially flush with the second surface 220. In some examples, the assembly also undergoes a cleaning process to remove any residue materials. Further, FIG. 26 represents the stage of fabrication following the application (e.g., lamination) of the second buffer layer 216 on the second surface 220 of the glass core 202 as well as across the outer surface of the dielectric material 226 and the lower end of the CMIL 1902.

FIG. 27 represents the result of adding the conductive pads 235 on the buffer layers 214, 216 for the TGVs 204 and electrically coupling the TGVs 204 to the conductive pads 235 with conductive vias 2702 extending through the buffer layers 214, 216. Further, FIG. 27 represents the adding of the conductive pads 234 on the buffer layers 214, 216 for the CMIL 1902 and electrically coupling the conductive material 230 in the CMIL 1902 with the conductive pads 234 with conductive vias 2704 extending through the buffer layers 214, 216. More particularly, in some examples, openings (e.g., vias) are provided (e.g., drilled) through the buffer layers and subsequently filled (e.g., via plating) to define the conductive vias 2702 with the locations of the conductive pads 234, 235 defined through a photolithography process. The structure of the example glass core assembly shown in FIG. 27 corresponds to the structure of the example glass core assembly 1900 shown in FIG. 19 and, thus, represents the completion of the fabrication process.

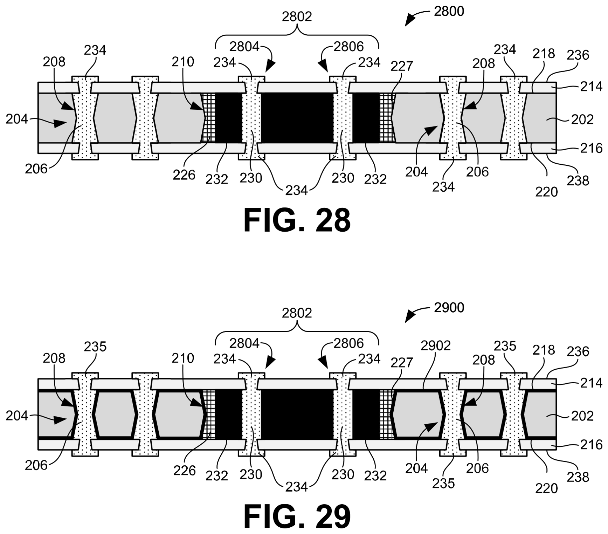

FIG. 28 illustrates another example glass core assembly 2800 that may be implemented within the example package substrate 112 of FIG. 1. The example glass core assembly 2800 of FIG. 28 is substantially the same as the example glass core assembly 1900 of FIG. 19 except as noted below and/or otherwise made clear from the context. Accordingly, the features shown in FIG. 28 that are the same or similar to corresponding features in FIG. 19 are identified by the same reference numbers. Further, the description of such features described above in connection with FIG. 19 applies similarly with respect to the corresponding features in FIG. 28.

The example of FIG. 28 differs from the example of FIG. 19 in the construction of the example CMIL 2802 (e.g., an electronic component) embedded within the cavity 210 in the glass core 202. Specifically, in FIG. 19, the two separate portions 1904, 1908 of the CMIL 1902 are defined by two separate regions of magnetic material 232. That is, in the illustrated example of FIG. 19, the different regions of magnetic material 232 are separated by a portion of the dielectric material 226. By contrast, in the illustrated example of FIG. 20, the magnetic material 232 associated with the first and second portions 2804, 2806 of the CMIL 2802 are defined by one continuous mass of magnetic material 232. In other words, in the illustrated example of FIG. 28, the first portion 2804 of the CMIL 2802 includes a first portion of the conductive material 230 and a first portion of magnetic material 232 that surrounds the first portion of the conductive material, where the first portion of the magnetic material 232 is a continuous extension of a second portion of the magnetic material 232 associated with the second portion 2806 of the CMIL 2802.

FIG. 29 illustrates another example glass core assembly 2900 that may be implemented within the example package substrate 112 of FIG. 1. The example glass core assembly 2900 of FIG. 29 is substantially the same as the example glass core assembly 2800 of FIG. 28 except as noted below and/or otherwise made clear from the context. Accordingly, the features shown in FIG. 29 that are the same or similar to corresponding features in FIG. 28 are identified by the same reference numbers. Further, the description of such features described above in connection with FIG. 28 applies similarly with respect to the corresponding features in FIG. 29.

The example of FIG. 29 differs from the example of FIG. 28 based on the inclusion of a thin film dielectric 2902 (e.g., dielectric layer) that coats the exterior surfaces of the glass core 202. In some examples, the thin film dielectric 2902 is substantially the same as the thin film dielectric 302 of FIG. 3A. Accordingly, the description of the thin film dielectric 2002 described above in connection with FIG. 20 applies similarly with respect to the thin film dielectric 2902 of FIG. 29.

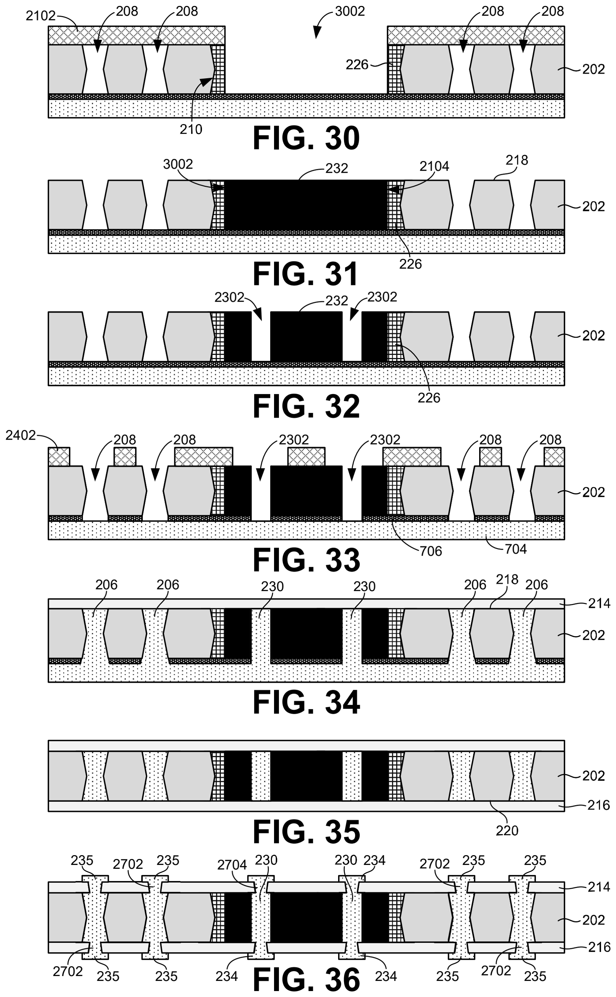

The process to fabricate the example glass core assemblies 2800, 2900 of FIGS. 28 and 29 can follow the same or similar processes detailed above in connection with the different stages of fabrication for the example glass core assemblies 1900, 2000 of FIGS. 19 and 20. FIGS. 30-36 illustrate different stages in the process flow to manufacture the example glass core assemblies 2800, 2900 of FIGS. 28 and 29. As can be seen, FIGS. 30-36 generally correspond to FIGS. 21-26, respectively. As such, the same reference numbers are used to refer to the same or similar features and the details provided above in connection with the description of FIGS. 21-26 apply similarly to FIGS. 30-36.

A main difference between the process flow represented in FIGS. 21-27 and the example process flow represented in FIGS. 30-36 occurs at the stage of fabrication represented in FIG. 30 (generally corresponding to FIG. 21). Specifically, as shown in FIG. 21, two separate holes 2104 are produced (e.g., machined, drilled, etc.) through the mask 2102 and the dielectric material 226 within the cavity 210 of the glass core 202. By contrast, in FIG. 30, a single (larger) hole 3002 is produced (e.g., machined, drilled, etc.) through the mask 2102 and the dielectric material 226 within the cavity 210 of the glass core 202. In this example, the hole 3002 in FIG. 30 corresponds to the combined area of the two holes 2104 in FIG. 21 plus the area between the two holes 2104. In other examples, the hole 3002 produced at the stage of manufacture represented in FIG. 30 can be larger or smaller than what is shown.

The stages of fabrication represented by FIGS. 31-36 generally correspond to what was described above in connection with FIGS. 22-27, with the main difference arising from the single hole 3002 produced in FIG. 31 instead of two separate holes 2104 as discussed above in connection with FIG. 21. Thus, FIG. 31 represents the stage of fabrication following the filling of the single holes 3002 with the magnetic material 232 used in the CMIL 212 and subsequent removal of the mask 2102, similar to what is described above in FIG. 22. FIG. 32 represents the stage of fabrication following the drilling of inner through-holes 2302 through the magnetic material 232, similar to what is described above in connection with FIG. 23. However, rather than the through-holes 2302 being drilled through the different portions of the magnetic material 232 (as in FIG. 23), the through-holes 2302 are drilled through the same (single) mass of magnetic material 232 within the same (single) hole 3002. FIG. 33 represents the stage of fabrication following the application of another mask 2402 and subsequent etching process to remove portions of the release layer 706, similar to what is described above in connection with FIG. 24. FIG. 34 represents the stage of fabrication following the removal of the mask 2402, the subsequent plating of the conductive material 206 within the through-holes 208, 2302, and the application of the first buffer layer 214, similar to what is described above in connection with FIG. 25. FIG. 35 represents the stage of fabrication following the removal of the conductive carrier 702 and the subsequent application of the second buffer layer 216, similar to what is described above in connection with FIG. 26. Finally, FIG. 36 represents the result of adding the conductive pads 234, 235 and associated vias 2702, 2704, similar to what is described above in connection with FIG. 27. The structure of the example glass core assembly shown in FIG. 36 corresponds to the structure of the example glass core assembly 2800 shown in FIG. 28 and, thus, represents the completion of the fabrication process.

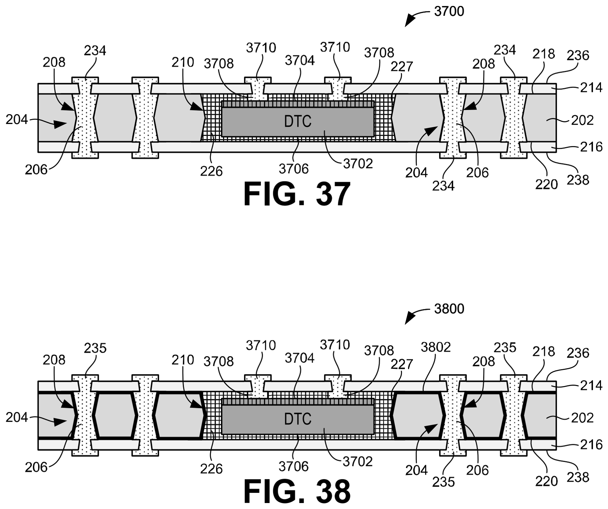

FIG. 37 illustrates another example glass core assembly 3700 that may be implemented within the example package substrate 112 of FIG. 1. The example glass core assembly 3700 of FIG. 37 is substantially the same as the example glass core assembly 200 of FIGS. 2A-2E except as noted below and/or otherwise made clear from the context. Accordingly, the features shown in FIG. 37 that are the same or similar to corresponding features in FIGS. 2A-2E (and associated FIGS. 4-18) are identified by the same reference numbers. Further, the description of such features described above in connection with FIGS. 2A-2E (and associated FIGS. 4-18) applies similarly with respect to the corresponding features in FIG. 37.

The example of FIG. 37 differs from the example of FIG. 2A in the type of electronic component embedded within the cavity 210 in the glass core 202. Specifically, in FIG. 2A, the example CMIL 212 is embedded within the cavity 210. By contrast, in the illustrated example of FIG. 37, a capacitor 3702 (e.g., a deep trench capacitor) is embedded within the cavity 210. In this example, the capacitor 3702 is a deep trench capacitor that is implemented on a semiconductor (e.g., silicon) substrate. That is, in this example, the capacitor 3702 is a semiconductor die (e.g., similar to the semiconductor dies 108, 110 of FIG. 1).

In some examples, the capacitor 3702 includes a first surface 3704 (e.g., an upper surface) and a second surface 3706 (e.g., a lower surface) that is opposite the first surface 3704 to define a thickness of the capacitor 3702. In some examples, as shown in FIG. 37, the thickness of the capacitor 3702 is less than the thickness of the glass core 202. In other examples, the thickness of the capacitor 3702 approximately equals the thickness of the glass core 202.

As shown in the illustrated example of FIG. 37, the capacitor 3702 is encased in (e.g., enclosed by, surrounded by) the dielectric material 226. Thus, in some examples, the dielectric material 226 separates the capacitor 3702 from the sidewalls 227 of the cavity 210 of the glass core 202. In some examples, at least one of the first or second surfaces 3704, 3706 of the capacitor 3702 (both in the illustrated example) are inset or recessed relative to the adjacent outer surfaces 218, 220 of the glass core 202. In such examples, the inset surface(s) 3704, 3706 are covered by the dielectric material 226. That is, as shown in the illustrated example, the dielectric material 226 separates the capacitor 3702 from the buffer layers 214, 216. In other examples, at least one of the first or second surfaces of the capacitor 3702 is substantially flush with an adjacent outer surface 218, 220 of the glass core 202. In some such examples, the associated buffer layer(s) 214, 216 can be in direct contact with the surface(s) 3704, 3706 of the capacitor 3702.

In this example, the capacitor 3702 includes two contact pads 3708 on the first surface 3704 that are electrically coupled to conductive pads 3710 on the first buffer layer 214 by conductive vias extending through the first buffer layer 214. In this example, the contact pads 3708 protrude outward from the first surface 3704 of the capacitor 3702 resulting in the first surface 3704 being recessed or inset relative to the outer surface 218 of the glass core 202. In other examples, the contact pads 3708 of the capacitor 3702 can be embedded within and flush with the first surface 3704 of the capacitor 3702.

FIG. 38 illustrates another example glass core assembly 3800 that may be implemented within the example package substrate 112 of FIG. 1. The example glass core assembly 3800 of FIG. 38 is substantially the same as the example glass core assembly 3700 of FIG. 37 except as noted below and/or otherwise made clear from the context. Accordingly, the features shown in FIG. 38 that are the same or similar to corresponding features in FIG. 37 are identified by the same reference numbers. Further, the description of such features described above in connection with FIG. 37 applies similarly with respect to the corresponding features in FIG. 38.

The example of FIG. 38 differs from the example of FIG. 37 based on the inclusion of a thin film dielectric 3802 (e.g., dielectric layer) that coats the exterior surfaces of the glass core 382. In some examples, the thin film dielectric 3802 is substantially the same as the thin film dielectric 302 of FIG. 3A. Accordingly, the description of the thin film dielectric 302 described above in connection with FIG. 3A (and associated FIGS. 3B-3E) applies similarly with respect to the thin film dielectric 3802 of FIG. 38.

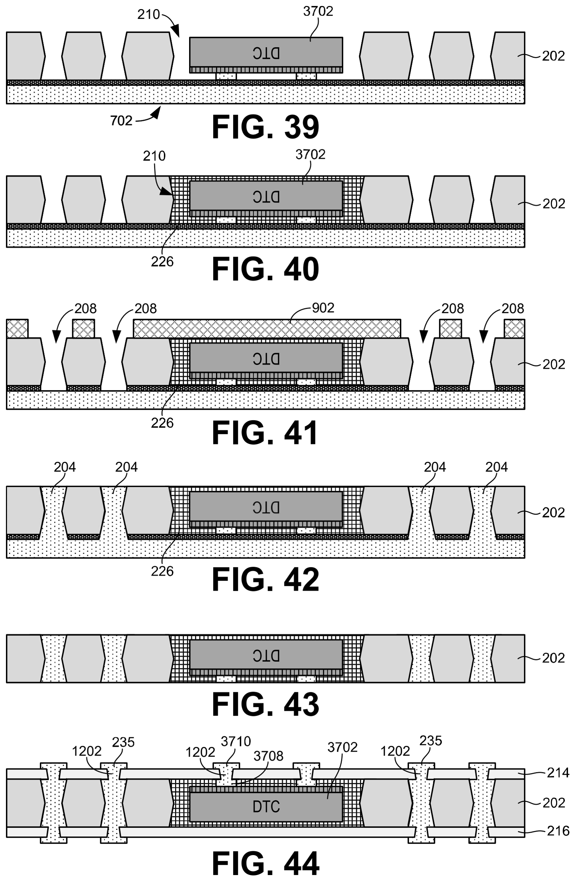

The process to fabricate the example glass core assemblies 3700, 3800 of FIGS. 37 and 38 can follow the same or similar processes detailed above in connection with the different stages of fabrication represented by FIGS. 4-7 discussed above in connection with the example glass core assemblies 380, 300 of FIGS. 2A and 3A. However, after the stage of fabrication represented in FIG. 7, the subsequent processes may diverge. FIGS. 39-44 illustrate different stages in the subsequent process flow to manufacture the example glass core assemblies 3700, 3800 of FIGS. 37 and 38.

FIG. 39 represents the stage of fabrication following the placement of the capacitor 3702 onto the conductive carrier 702 within the cavity 210 of the glass core 202. In some examples, the capacitor 3702 is placed upside down (e.g., with the first (upper) surface 3704 facing downwards towards the conductive carrier 702). In some such examples, the glass core 202 is also upside down (e.g., the first surface 218 facing downwards towards the conductive carrier 702). In other examples, the capacitor 3702 maintains a right-side up orientation when placed within the cavity 210.

The stages of fabrication represented in FIGS. 40-43 generally correspond to the process flow described above in connection with FIGS. 8-11, except for the presence of the capacitor 3702 within the cavity. Thus, the description provided above for FIGS. 8-11 applies similar to the stages of fabrication represented in FIGS. 40-43 except as noted below and/or otherwise made clear from the context. Specifically, FIG. 40 represents the stage of fabrication after the cavity 210 in the glass core 202 is filled with the dielectric material 226, similar to what is described above in connection with FIG. 8. In this example, the dielectric material 226 is dispensed around the capacitor 3702 already positioned within the cavity 210. Thus, the dielectric material 226 surrounds (e.g., encapsulates, encases, etc.) the capacitor 3702. FIG. 41 represents the stage of fabrication following the application of the mask 902 and subsequent etching process to remove portions of the release layer 706, similar to what is described above in connection with FIG. 9. FIG. 42 represents the stage of fabrication following the removal of the mask 902 and subsequent plating of the conductive material 206 within the through-holes 208 to define the TGVs 204, similar to what is described above in connection with FIG. 10. FIG. 43 represents the stage of fabrication following the removal of the conductive carrier 702, similar to what is described above in connection with FIG. 11.

FIG. 44 represents the stage of fabrication following the application (e.g., lamination) of the first and second buffer layers 214, 216 on the respective outer surfaces 218, 220 of the glass core 202 as well as across the outer surfaces of the dielectric material 226 within the cavity 210. FIG. 44 also represents the result of adding conductive vias 1202 through the buffer layers 214, 216 to electrically couple the underlying TGVs 204 to the corresponding conductive pads 235 and to electrically couple the contact pads 3708 of the capacitor 3702 with the corresponding conductive pads 3710. outer layers of conductive material 1204. More particularly, holes (e.g., vias) are drilled through the buffer layers 214, 216 to expose the ends of the TGVs 204 and the contact pads 3708 of the capacitor 3702. Then, the holes are filled to define the material of the conductive vias 1206 and to produce the conductive pads 235, 3710. FIG. 44 also represents the entire assembly being inverted or flipped over so that the capacitor 3702 is right-side up. The structure of the example glass core assembly shown in FIG. 44 corresponds to the structure of the example glass core assembly 3700 shown in FIG. 37 and, thus, represents the completion of the fabrication process.

The foregoing examples of the glass core assemblies 200, 300, 1900, 2000, 2800, 2900, 3700, 3800 teach or suggest different features. Although each example glass core assemblies 200, 300, 1900, 2000, 2800, 2900, 3700, 3800 disclosed above have certain features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features. Thus, for example, two or more different CMIL structures, as shown in FIGS. 2A, 3A, 19, 20, 28 and 29, can be implemented within the same glass core (e.g., either within the same cavity or different cavities within the glass core). Furthermore, the capacitor 3702 of FIG. 37 and 38 can be implemented in the same glass core as any of the CMIL structures of FIGS. FIGS. 2A, 3A, 19, 20, 28 and 29 (e.g., either within the same cavity or different cavities within the glass core).

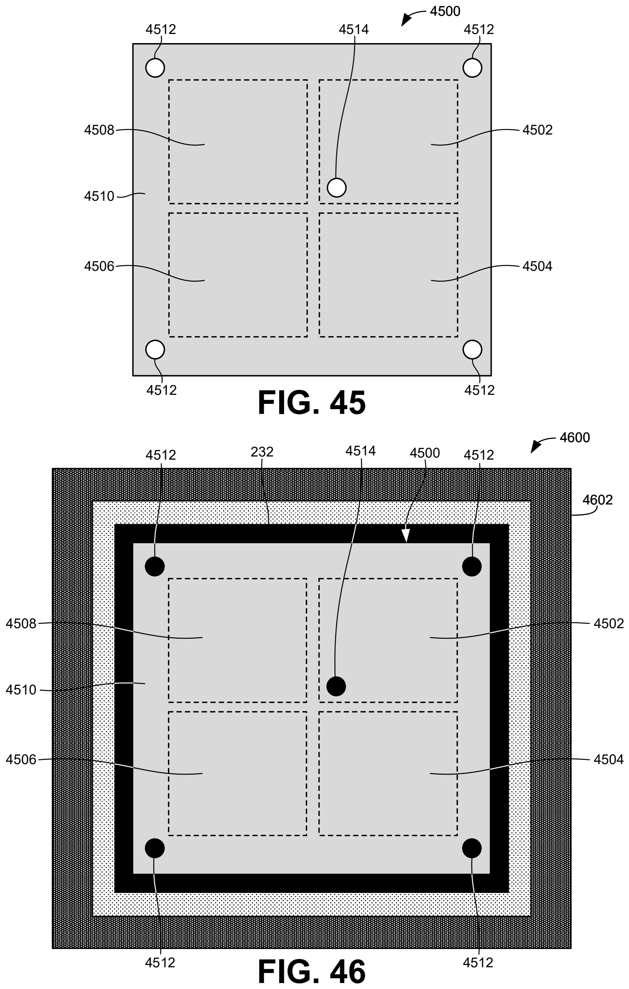

FIG. 45 illustrates an example glass panel 4500 that may be processed in accordance with teachings disclosed herein to produce any of the example glass core assemblies 200, 300, 1900, 2000, 2800, 2900, 3700, 3800 of FIGS. 2A, 3A, 19, 20, 28, 29, 37, and 38. In the illustrated example, the glass panel 4500 defines for separate active areas 4502, 4504, 4506, 4508 corresponding to regions associated with a particular glass core (e.g., the glass core 132 of FIG. 1) for a particular package substrate (e.g., the package substrate 112 of FIG. 1). That is, during a subsequent stage of fabrication, the example glass panel 4500 of FIG. 45 is to be cut or singulated into four separate pieces to serve as the basis for four separate package substrates. The area outside of the active areas 4502, 4504, 4506, 4508 is referred to as the keep out zone (KOZ) 4510.

As shown in FIG. 45, the KOZ 4510 of the glass panel 4500 includes one or more tooling holes 4512. The tooling holes can facilitate the manipulation and/or positioning of the glass panel4500 and/or facilitate the alignment of fabrication tools relative to the glass panel 4500 during various stages of fabrication. That is, in some examples, the tooling holes 4512 serve as fiducial markers used for alignment purposes. Although four tooling holes 4512 are shown in the KOZ 4510, in other examples, a different number of tooling holes 4512 may be implemented. In some examples, the tooling holes 4512 are omitted. Further, while tooling holes 4512 are most commonly implemented in the KOZ 4510 (so as not to take up space within the active areas 4502, 4504, 4506, 4508), in some examples, one or more additional tooling hole 4514 is included in one or more of the active areas 4502, 4504, 4506, 4508. In this example, one additional tooling hole 4514 is included in one of the active areas (e.g., the first active area 4502). In other examples, more than one (e.g., all) of the active areas 4502, 4504, 4506, 4508 includes one or more tooling hole 4514. In other examples, none of the active areas 4502, 4504, 4506, 4508 include a tooling hole 4514.

In some examples, the tooling holes 4512, 4514 are fabricated during the same fabrication processes used to produce the through-holes 208 for the TGVs 204 and the cavity 210 to contain an electronic component (e.g., one or more of the CMILs 212, 1902, 2802 and/or the capacitor 3702, etc.). That is, in some examples, the tooling holes 4512, 4514 are fabricated during the LIDE process discussed above in connection with FIGS. 5 and 6. In the illustrated example of FIG. 45, the through-holes 208 and the cavity 210 are not shown for purposes of simplicity. Moreover, the tooling holes 4512, 4514 are typically much larger than the through-holes 208 and may be much larger than the cavity 210.

Inasmuch as the tooling holes 4512, 4514 are made at the same time the through-holes 208 and the cavity 210, in examples that include the thin film dielectric 302, 2002, 2902, 3802, the inner sidewalls of the tooling holes 4512, 4514 are lined or coated with the thin film dielectric 302, 2002, 2902, 3802. However, due to the large size of the tooling holes 4512, 4514 relative to the other openings in the glass panel 4500 (e.g., the through-holes 208 and the cavity 210), the tooling holes 4512, 4514 will not be filled with the conductive material 206 during the bottom-up plating process implemented to form the TGVs 204 (as discussed above in connection with FIGS. 9 and 10). That is, even after the plating process that produces the TGVs 204, the tooling holes 4512, 4514 will remain empty. As a result, in some examples, the tooling holes 4512, 4514 are filled with a different material applied during a later fabrication process. More particularly, in some examples, the tooling holes 4512, 4514 will be filled with the magnetic material 232. As discussed above in connection with FIG. 14, in some examples, the magnetic material 232 is deposited as a paste or resin that is subsequently cured. More particularly, in some examples, the magnetic material 232 is applied as a paste across the entire surface of the glass panel 4500, thereby resulting in the tooling holes 4512, 4514 being filled with the magnetic material 232 as represented in FIG. 46.

FIG. 46 illustrates an example reconstituted panel 4600 that includes the example glass panel 4500 of FIG. 45 within an example frame 4602. The example frame 4602 enables compatibility with fabrication tools designed specifically for organic cores as opposed to glass cores. That is, the example frame 4602 enables the glass panel 4500 to be processed using fabrication techniques typically intended for organic cores while protecting the glass panel 4500 from damage. As shown in FIG. 46, the tooling holes 4512, 4514 are filled with the magnetic material 232, which also extends around an outer perimeter of the glass panel 4500. In some examples, a different material extends along the outer perimeter of the glass panel 4500 with the magnetic material 232 still filling the tooling holes 4512, 4514. Thus, the presence of the magnetic material 232 within the tooling holes 4512, 4514 is an indication that the example fabrication process disclosed herein was followed when developing the glass panel 4500 of FIG. 5

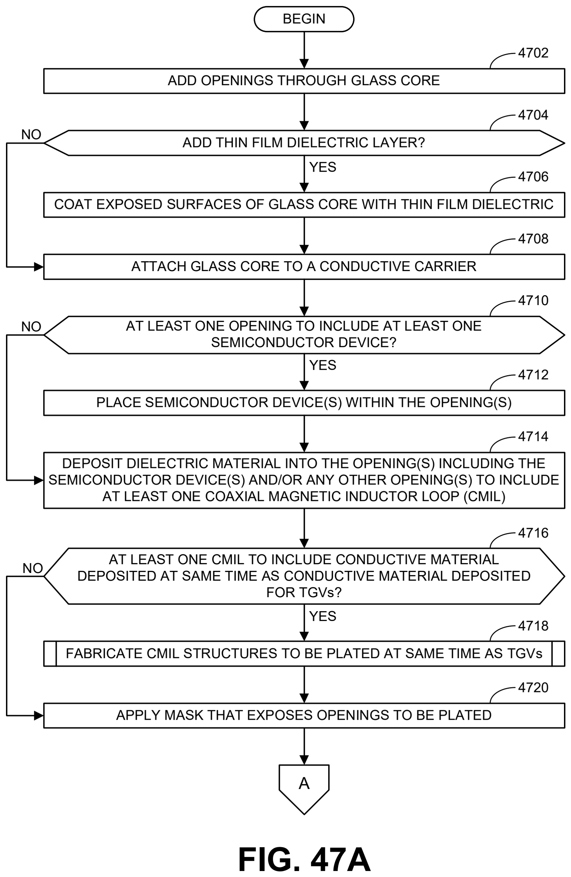

FIGS. 47A-49 are flowcharts representative of an example method of manufacturing any one of the example glass core assemblies 200, 300, 1900, 2000, 2800, 2900, 3700, 3800 of FIGS. 2A, 3A, 19, 20, 28, 29, 37, and 38 that may be implemented in the example IC package 100 of FIG. 1. In some examples, some or all of the operations outlined in the example method of FIGS. 47A-49 are performed automatically by fabrication equipment that is programmed to perform the operations. That is, in some examples, the example method or portions thereof may be implemented and/or controlled by one or more processor circuits executing instructions based on data from sensors and/or user inputs. Although the example method of manufacture is described with reference to the flowcharts illustrated in FIGS. 47A-49, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example process begins at block 4702 by adding openings through a glass core (e.g., the glass core 202). In some examples, the glass core 202 at this stage of fabrication is part of a glass panel, such as the example glass panel 4500 of FIG. 45. In some examples, the openings added to the glass core 202 include the through-holes 208 for the TGVs 204, the cavity 210 to contain an electronic component, and/or the tooling holes 4512, 4514. In some examples, the openings are added through a LIDE process as discussed above in connection with FIGS. 5 and 6.

At block 4704, the example process involves determining whether to add a thin film dielectric layer. If so, the process advances to block 4706 where exposed surfaces of the glass core are coated with a thin film dielectric (e.g., the thin film dielectric 302, 2002, 2902, 3802). Thereafter, the process advances to block 4708. If no thin film dielectric layer is to be added (as determined at block 4704), the process advances directly to block 4708.

At block 4708, the example process involves attaching the glass core to a conductive carrier (e.g., the conductive carrier 702 as discussed above in connection with FIG. 7). At block 4710, the example process involves determining whether at least one opening is to include at least one semiconductor device (e.g., the capacitor 3702 and/or any other suitable semiconductor device). If so, the process advances to block 4712 where the semiconductor device(s) are placed within the opening(s) (e.g., the capacitor 3702 is placed with the cavity 210 as discussed above in connection with FIG. 39). Thereafter, the process advances to block 4714. If no semiconductor device is to be included (as determined at block 4710), the process advances directly to block 4714.

At block 4714, the example process involves depositing a dielectric material (e.g., the dielectric material 226) into the opening(s) (e.g., the cavity 210) including the semiconductor device(s) and/or any other opening(s) (e.g., other cavities 210) to include at least one CMIL (e.g., at least one of the CMILs 212, 1902, 2802).

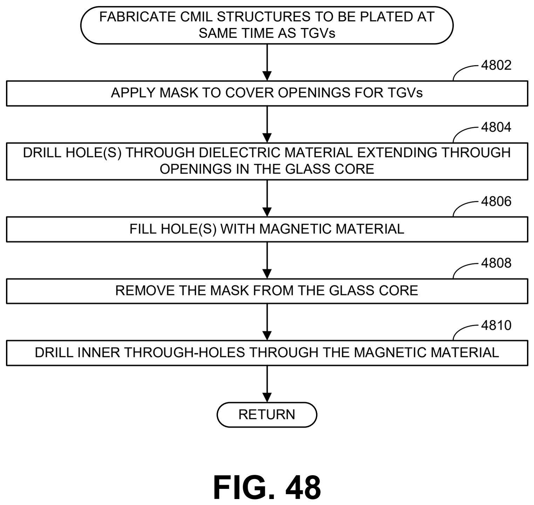

At block 4716, the example process involves determining whether at least one CMIL is to include a conductive material (e.g., the conductive material 230) deposited at a same time as (e.g., concurrently with) the conductive material (e.g., the conductive material 206) deposited for the TGVs 204. If so, the process advances to block 4706 where CMIL structures are fabricated to be plated at the same time as the TGVs 204. Further detail regarding the implementation of block 4718 is provided below in connection with FIG. 48. Thereafter, the process advances to block 4720. If no CMILs are to include conductive material deposited at the same time as the conductive material for the TGVs (as determined at block 4716), the process advances directly to block 4720.

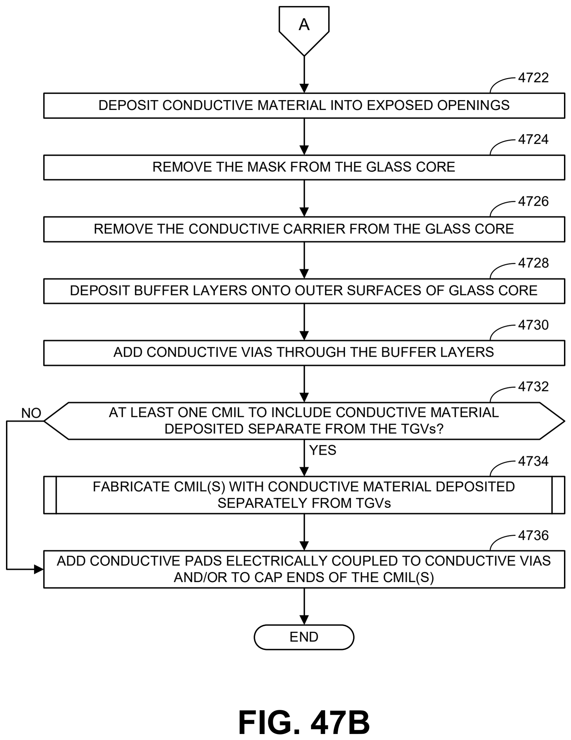

At block 4720, the example process involves applying a mask (e.g., any one of the masks 902, 2402 discussed above in connection with FIGS. 9, 24, 33, 41) that exposes openings to be plated. In some examples, these openings include the through-holes 208 for the TGVs 204 while the cavities 210 are covered as shown and described in connection with FIGS. 9 and 41. In some examples, the openings also include the inner through-holes 2302 within the magnetic material 232 inside the cavities 210 as shown and described in connection with FIGS. 23 and 32. Thereafter, the process advances to block 4722 shown at the top of FIG. 47B.

At block 4722, the example process involves depositing conductive material into the exposed openings. In examples where only the through-holes 208 for the TGVs 204 are exposed, the conductive material corresponds to the conductive material 206 as discussed above in connection with FIGS. 10 and 42. In examples where the inner through-holes 2302 within the magnetic material 232 are also exposed, the conductive material corresponds to both the conductive material 206 and the conductive material 230 within the CMILs 1902, 2802 as discussed above in connection with FIGS. 25 and 34.

At block 4724, the example process involves removing the mask 902, 2402 from the glass core 202. At block 4726, the example process involves removing the conductive carrier 702 from the glass core 202. At block 4728, the example process involves depositing the buffer layers (e.g., the buffer layers 214, 216) onto the outer surfaces 218, 220 of the glass core 202. In some examples, the first buffer layer 214 can be added before the conductive carrier 702 is removed (as represented in FIGS. 25 and 26 or FIGS. 34 and 35). In other examples, the conductive carrier 702 is removed before either buffer layer 214, 216 is added (as represented in FIGS. 11 and 12 or FIGS. 43 and 44).

At block 4730, the example process involves adding conductive vias (e.g., the conductive vias 1202, 2702, 2704 discuss above in connection with FIGS. 12, 27, 36, 44) through the buffer layers 214, 216. In some examples, the conductive vias connect to the underlying TGVs 204, the underlying copper cores of the CMILs, and/or the underlying contact pads 3708 of the capacitor 3702.

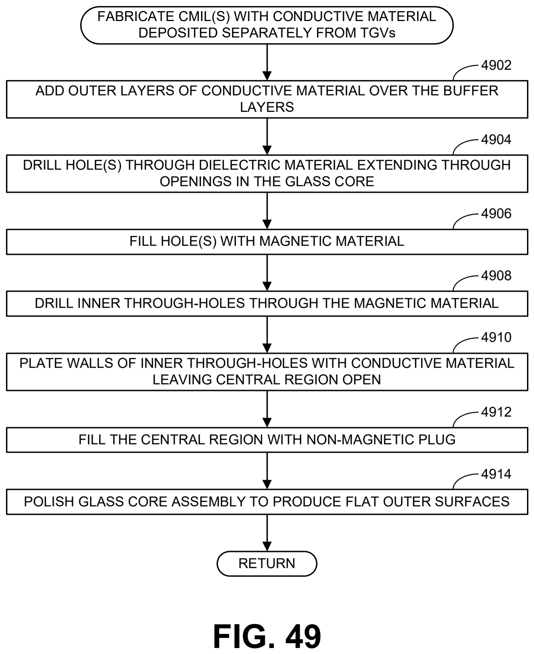

At block 4732, the example process involves determining whether at least one CMIL is to include a conductive material (e.g., the conductive material 230) deposited separate from the TGVs 204. If so, the process advances to block 4734 where the CMIL(s) are fabricated with conductive material deposited separately from the TGVs 204. In some examples, separate plating of the CMILs is employed to enable the inclusion of a non-magnetic plug (e.g., the non-magnetic plug 228). Further detail regarding the implementation of block 4734 is provided below in connection with FIG. 49. Thereafter, the process advances to block 4736. If no CMILs are to include conductive material deposited separately from the TGVs (as determined at block 4732), the process advances directly to block 4736.

At block 4736, the example process involves adding conductive pads to be electrically coupled to the conductive vias (added at block 4730) and/or to cap ends of the CMIL(s) (as described in connection with FIGS. 17 and 18). Thereafter, the example process of FIGS. 47A and 47B ends.

FIG. 48 is a flowchart representative of an example process of implementing block 4718 of FIG. 47A. The example process begins at block 4802 where a mask (e.g., the mask 2102 described above in connection with FIGS. 21 and 30) is applied to cover openings for the TGVs 204 (e.g., the through-holes 208). At block 4804, the example process involves drilling hole(s) through the dielectric material extending through the openings in the glass core 202. In some examples, the hole(s) are also drilled through the mask 2102. In some examples, multiple holes (e.g., the holes 2104 of FIG. 21) are drilled to define different portions of a given CMIL (e.g., the different portions 1904, 1906 of the CMIL 1902). In other examples, a single hole (e.g., the hole 3002 of FIG. 30) is drilled to define the area of all portions of a given CMIL (e.g., both portions 2804, 2806 of the CMIL 2802).

At block 4806, the example process involves filling the hole(s) with magnetic material (e.g., the magnetic material 232 as described above in connection with FIGS. 22 and 31). As discussed above, in some examples, the magnetic material 232 is added as a paste that covers the entire underlying assembly. Accordingly, in some examples, the magnetic material 232 also fills the tooling holes 4512, 4514. The magnetic material 232 within the tooling holes 4512, 4514 serves no purpose but is a result of the fabrication process disclosed herein.

At block 4808, the example process involves removing the mask 2102 from the glass core 202. At block 4810, the example process involves drilling inner through-holes (e.g., the inner through-holes 2302 as described above in connection with FIGS. 23 and 32) through the magnetic material 232. Thereafter, the example process of FIG. 48 ends and returns to complete the example process of FIGS. 47A and 47B.

FIG. 49 is a flowchart representative of an example process of implementing block 4734 of FIG. 47B. The example process begins at block 4902 by adding outer layers of conductive material (e.g., the outer layers of conductive material 1204 described above in connection with FIG. 12) over the buffer layers 214, 216. At block 4904, the example process involves drilling hole(s) through the dielectric material extending through the openings in the glass core 202. In some examples, the hole(s) are also drilled through the outer layers of conductive material 1204 as well as the buffer layers 214, 216. In some examples, multiple holes (e.g., the holes 1302 of FIG. 13) are drilled to define different portions of a given CMIL (e.g., the different portions 222, 224 of the CMIL 212). In other examples, a single hole is drilled to define the area of all portions of a given CMIL (e.g., similar to what is shown for the CMIL 2802 described above in connection with FIGS. 28-36).

At block 4906, the example process involves filling the hole(s) with magnetic material (e.g., the magnetic material 232 as described above in connection with FIG. 14). At block 4908, the example process involves drilling inner through-holes (e.g., the inner through-holes 1502 as described above in connection with FIG. 15) through the magnetic material 232.

At block 4910, the example process involves plating walls of the inner through-holes 1502 with a conductive material leaving a central region open (as shown and described in connection with FIG. 16). At block 4912, the example process involves filling the central region with a non-magnetic plug (e.g., the non-magnetic plug 228 shown in FIG. 16). At block 4914, the example process involves polishing the glass core assembly to produce flat outer surfaces. Thereafter, the example process of FIG. 49 ends and returns to complete the example process of FIGS. 47A and 47B.

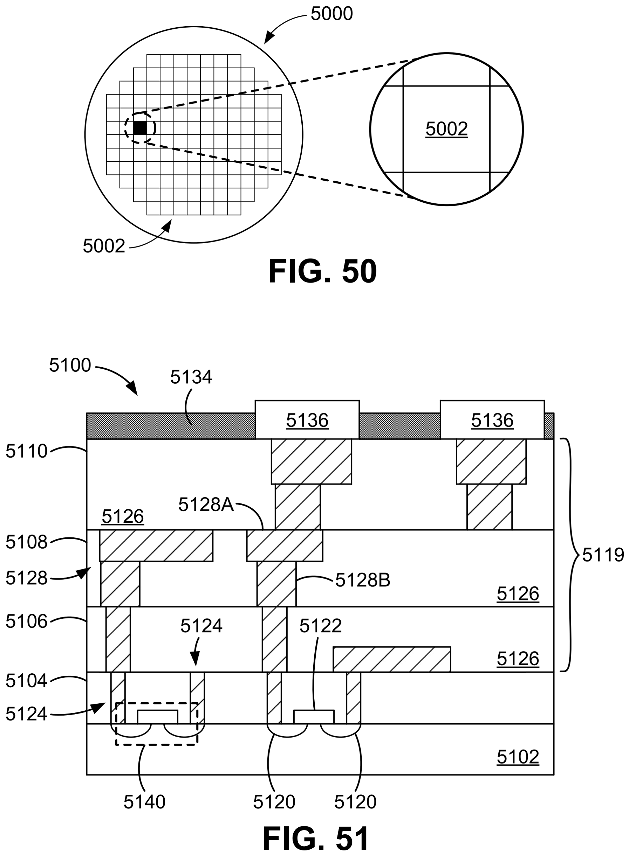

The example IC package 100 of FIG. 1 with any of the example glass core assemblies 200, 300, 1900, 2000, 2800, 2900, 3700, 3800 of FIGS. 2A, 3A, 19, 20, 28, 29, 37, and 38 disclosed herein may be included in any suitable electronic component. FIGS. 50-53 illustrate various examples of apparatus that may include or be included in the IC package 100 disclosed herein.

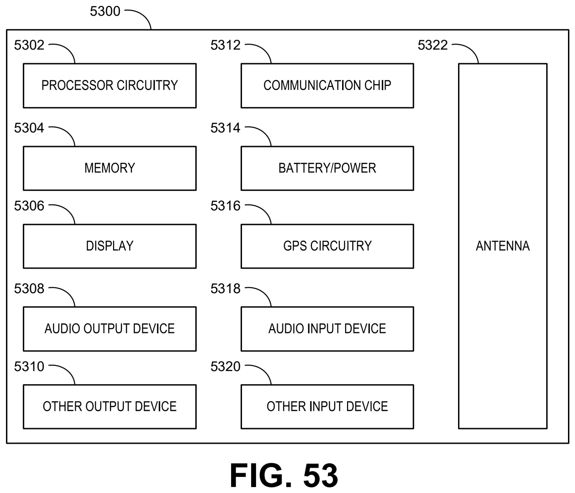

FIG. 50 is a top view of a wafer 5000 and dies 5002 that may be included in the IC package 100 of FIG. 1 (e.g., as any suitable ones of the dies 108, 110). The wafer 5000 includes semiconductor material and one or more dies 5002 having circuitry. Each of the dies 5002 may be a repeating unit of a semiconductor product. After the fabrication of the semiconductor product is complete, the wafer 5000 may undergo a singulation process in which the dies 5002 are separated from one another to provide discrete "chips." The die 5002 includes one or more transistors (e.g., some of the transistors 5140 of FIG. 51, discussed below), supporting circuitry to route electrical signals to the transistors, passive components (e.g., traces, resistors, capacitors, inductors, and/or other circuitry), and/or any other components. In some examples, the die 5002 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 5002. For example, a memory array of multiple memory circuits may be formed on a same die 5002 as programmable circuitry (e.g., the processor circuitry 5302 of FIG. 53) and/or other logic circuitry. Such memory may store information for use by the programmable circuitry. The example IC package 100 disclosed herein may be manufactured using a die-to-wafer assembly technique in which some dies are attached to a wafer 5000 that includes others of the dies, and the wafer 5000 is subsequently singulated.

FIG. 51 is a cross-sectional side view of an IC device 5100 that may be included in the example IC package 100 (e.g., in any one of the dies 108, 110). One or more of the IC devices 5100 may be included in one or more dies 5002 (FIG. 50). The IC device 5100 may be formed on a die substrate 5102 (e.g., the wafer 5000 of FIG. 50) and may be included in a die (e.g., the die 5002 of FIG. 50). The die substrate 5102 may be a semiconductor substrate including semiconductor materials including, for example, n-type or p-type materials systems (or a combination of both). The die substrate 5102 may include, for example, a crystalline substrate formed using a bulk silicon or a silicon-on-insulator (SOI) substructure. In some examples, the die substrate 5102 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 5102. Although a few examples of materials from which the die substrate 5102 may be formed are described here, any material that may serve as a foundation for an IC device 5100 may be used. The die substrate 5102 may be part of a singulated die (e.g., the dies 5002 of FIG. 50) or a wafer (e.g., the wafer 5000 of FIG. 50).

The IC device 5100 may include one or more device layers 5104 disposed on and/or above the die substrate 5102. The device layer 5104 may include features of one or more transistors 5140 (e.g., metal oxide semiconductor field-effect transistors (MOSFETs)) formed on the die substrate 5102. The device layer 5104 may include, for example, one or more source and/or drain (S/D) regions 5120, a gate 5122 to control current flow between the S/D regions 5120, and one or more S/D contacts 5124 to route electrical signals to/from the S/D regions 5120. The transistors 5140 may include additional features not depicted for the sake of clarity, such as device isolation regions, gate contacts, and the like. The transistors 5140 are not limited to the type and configuration depicted in FIG. 51 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 5140 may include a gate 5122 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 5140 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 5140 along the source-channel-drain direction, the gate electrode may include a U-shaped structure that includes a bottom portion substantially parallel to the surface of the die substrate 5102 and two sidewall portions that are substantially perpendicular to the top surface of the die substrate 5102. In other examples, at least one of the metal layers that form the gate electrode may be a planar layer that is substantially parallel to the top surface of the die substrate 5102 and does not include sidewall portions substantially perpendicular to the top surface of the die substrate 5102. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 5120 may be formed within the die substrate 5102 adjacent to the gate 5122 of corresponding transistor(s) 5140. The S/D regions 5120 may be formed using an implantation/diffusion process or an etching/deposition process, for example. In the former process, dopants such as boron, aluminum, antimony, phosphorous, or arsenic may be ion-implanted into the die substrate 5102 to form the S/D regions 5120. An annealing process that activates the dopants and causes them to diffuse farther into the die substrate 5102 may follow the ion-implantation process. In the latter process, the die substrate 5102 may first be etched to form recesses at the locations of the S/D regions 5120. An epitaxial deposition process may then be carried out to fill the recesses with material that is used to fabricate the S/D regions 5120. In some implementations, the S/D regions 5120 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 5120 may be formed using one or more alternate semiconductor materials such as germanium or a group III-V material or alloy. In further examples, one or more layers of metal and/or metal alloys may be used to form the S/D regions 5120.

Electrical signals, such as power and/or input/output (I/O) signals, may be routed to and/or from the devices (e.g., transistors 5140) of the device layer 5104 through one or more interconnect layers disposed on the device layer 5104 (illustrated in FIG. 51 as interconnect layers 5106-2010). For example, electrically conductive features of the device layer 5104 (e.g., the gate 5122 and the S/D contacts 5124) may be electrically coupled with the interconnect structures 5128 of the interconnect layers 5106-2010. The one or more interconnect layers 5106-2010 may form a metallization stack (also referred to as an "ILD stack") 5119 of the IC device 5100.

The interconnect structures 5128 may be arranged within the interconnect layers 5106-2010 to route electrical signals according to a wide variety of designs (in particular, the arrangement is not limited to the particular configuration of interconnect structures 5128 depicted in FIG. 51). Although a particular number of interconnect layers 5106-2010 is depicted in FIG. 51, examples of the present disclosure include IC devices having more or fewer interconnect layers than depicted.

In some examples, the interconnect structures 5128 may include lines 5128a and/or vias 5128b filled with an electrically conductive material such as a metal. The lines 5128a may be arranged to route electrical signals in a direction of a plane that is substantially parallel with a surface of the die substrate 5102 upon which the device layer 5104 is formed. For example, the lines 5128a may route electrical signals in a direction in and/or out of the page from the perspective of FIG. 51. The vias 5128b may be arranged to route electrical signals in a direction of a plane that is substantially perpendicular to the surface of the die substrate 5102 upon which the device layer 5104 is formed. In some examples, the vias 5128b may electrically couple lines 5128a of different interconnect layers 5106-2010 together.

The interconnect layers 5106-2010 may include a dielectric material 5126 disposed between the interconnect structures 5128, as shown in FIG. 51. In some examples, the dielectric material 5126 disposed between the interconnect structures 5128 in different ones of the interconnect layers 5106-2010 may have different compositions; in other examples, the composition of the dielectric material 5126 between different interconnect layers 5106-2010 may be the same.

A first interconnect layer 5106 (referred to as Metal 1 or "M1") may be formed directly on the device layer 5104. In some examples, the first interconnect layer 5106 may include lines 5128a and/or vias 5128b, as shown. The lines 5128a of the first interconnect layer 5106 may be coupled with contacts (e.g., the S/D contacts 5124) of the device layer 5104.

A second interconnect layer 5108 (referred to as Metal 2 or "M2") may be formed directly on the first interconnect layer 5106. In some examples, the second interconnect layer 5108 may include vias 5128b to couple the lines 5128a of the second interconnect layer 5108 with the lines 5128a of the first interconnect layer 5106. Although the lines 5128a and the vias 5128b are structurally delineated with a line within each interconnect layer (e.g., within the second interconnect layer 5108) for the sake of clarity, the lines 5128a and the vias 5128b may be structurally and/or materially contiguous (e.g., simultaneously filled during a dual-damascene process) in some examples.

A third interconnect layer 5110 (referred to as Metal 3 or "M3") (and additional interconnect layers, as desired) may be formed in succession on the second interconnect layer 5108 according to similar techniques and/or configurations described in connection with the second interconnect layer 5108 or the first interconnect layer 5106. In some examples, the interconnect layers that are "higher up" in the metallization stack 5119 in the IC device 5100 (i.e., further away from the device layer 5104) may be thicker.

The IC device 5100 may include a solder resist material 5134 (e.g., polyimide or similar material) and one or more conductive contacts 5136 formed on the interconnect layers 5106-2010. In FIG. 51, the conductive contacts 5136 are illustrated as taking the form of bond pads. The conductive contacts 5136 may be electrically coupled with the interconnect structures 5128 and configured to route the electrical signals of the transistor(s) 5140 to other external devices. For example, solder bonds may be formed on the one or more conductive contacts 5136 to mechanically and/or electrically couple a chip including the IC device 5100 with another component (e.g., a circuit board). The IC device 5100 may include additional or alternate structures to route the electrical signals from the interconnect layers 5106-2010; for example, the conductive contacts 5136 may include other analogous features (e.g., posts) that route the electrical signals to external components.

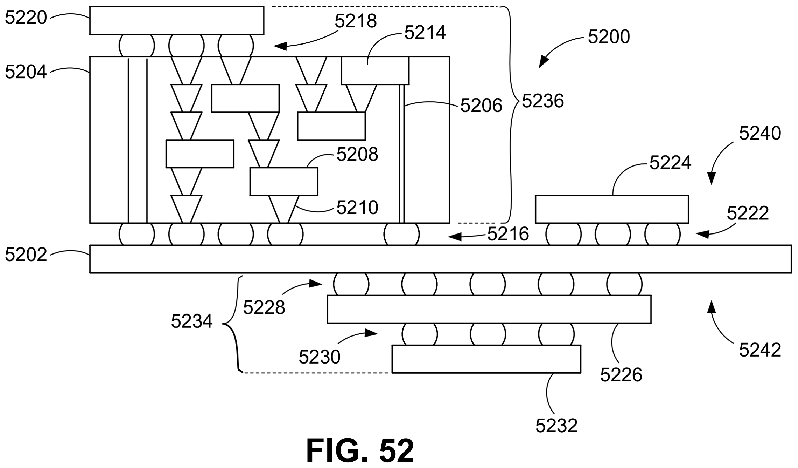

FIG. 52 is a cross-sectional side view of an IC device assembly 5200 that may include the IC package 100 disclosed herein. In some examples, the IC device assembly corresponds to the IC package 100. The IC device assembly 5200 includes a number of components disposed on a circuit board 5202 (which may be, for example, a motherboard). The IC device assembly 5200 includes components disposed on a first face 5240 of the circuit board 5202 and an opposing second face 5242 of the circuit board 5202; generally, components may be disposed on one or both faces 5240 and 5242. Any of the IC packages discussed below with reference to the IC device assembly 5200 may take the form of the example IC package 100 of FIG. 1.

In some examples, the circuit board 5202 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 5202. In other examples, the circuit board 5202 may be a non-PCB substrate.

The IC device assembly 5200 illustrated in FIG. 52 includes a package-on-interposer structure 5236 coupled to the first face 5240 of the circuit board 5202 by coupling components 5216. The coupling components 5216 may electrically and mechanically couple the package-on-interposer structure 5236 to the circuit board 5202, and may include solder balls (as shown in FIG. 52), male and female portions of a socket, an adhesive, an underfill material, and/or any other suitable electrical and/or mechanical coupling structure.

The package-on-interposer structure 5236 may include an IC package 5220 coupled to an interposer 5204 by coupling components 5218. The coupling components 5218 may take any suitable form for the application, such as the forms discussed above with reference to the coupling components 5216. Although a single IC package 5220 is shown in FIG. 52, multiple IC packages may be coupled to the interposer 5204; indeed, additional interposers may be coupled to the interposer 5204. The interposer 5204 may provide an intervening substrate used to bridge the circuit board 5202 and the IC package 5220. The IC package 5220 may be or include, for example, a die (the die 5002 of FIG. 50), an IC device (e.g., the IC device 5100 of FIG. 51), or any other suitable component. Generally, the interposer 5204 may spread a connection to a wider pitch or reroute a connection to a different connection. For example, the interposer 5204 may couple the IC package 5220 (e.g., a die) to a set of BGA conductive contacts of the coupling components 5216 for coupling to the circuit board 5202. In the example illustrated in FIG. 52, the IC package 5220 and the circuit board 5202 are attached to opposing sides of the interposer 5204; in other examples, the IC package 5220 and the circuit board 5202 may be attached to a same side of the interposer 5204. In some examples, three or more components may be interconnected by way of the interposer 5204.

In some examples, the interposer 5204 may be formed as a PCB, including multiple metal layers separated from one another by layers of dielectric material and interconnected by electrically conductive vias. In some examples, the interposer 5204 may be formed of an epoxy resin, a fiberglass-reinforced epoxy resin, an epoxy resin with inorganic fillers, a ceramic material, or a polymer material such as polyimide. In some examples, the interposer 5204 may be formed of alternate rigid or flexible materials that may include the same materials described above for use in a semiconductor substrate, such as silicon, germanium, and other group III-V and group IV materials. The interposer 5204 may include metal interconnects 5208 and vias 5210, including but not limited to through-silicon vias (TSVs) 5206. The interposer 5204 may further include embedded devices 5214, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 5204. The package-on-interposer structure 5236 may take the form of any of the package-on-interposer structures known in the art.

The IC device assembly 5200 may include an IC package 5224 coupled to the first face 5240 of the circuit board 5202 by coupling components 5222. The coupling components 5222 may take the form of any of the examples discussed above with reference to the coupling components 5216, and the IC package 5224 may take the form of any of the examples discussed above with reference to the IC package 5220.

The IC device assembly 5200 illustrated in FIG. 52 includes a package-on-package structure 5234 coupled to the second face 5242 of the circuit board 5202 by coupling components 5228. The package-on-package structure 5234 may include a first IC package 5226 and a second IC package 5232 coupled together by coupling components 5230 such that the first IC package 5226 is disposed between the circuit board 5202 and the second IC package 5232. The coupling components 5228, 5230 may take the form of any of the examples of the coupling components 5216 discussed above, and the IC packages 5226, 5232 may take the form of any of the examples of the IC package 5220 discussed above. The package-on-package structure 5234 may be configured in accordance with any of the package-on-package structures known in the art.

FIG. 53 is a block diagram of an example electrical device 5300 that may include one or more of the example IC package 100. For example, any suitable ones of the components of the electrical device 5300 may include one or more of the device assemblies 5200, IC devices 5100, or dies 5002 disclosed herein, and may be arranged in the example IC package 100. A number of components are illustrated in FIG. 53 as included in the electrical device 5300, but any one or more of these components may be omitted or duplicated, as suitable for the application. In some examples, some or all of the components included in the electrical device 5300 may be attached to one or more motherboards. In some examples, some or all of these components are fabricated onto a single system-on-a-chip (SoC) die.

Additionally, in various examples, the electrical device 5300 may not include one or more of the components illustrated in FIG. 53, but the electrical device 5300 may include interface circuitry for coupling to the one or more components. For example, the electrical device 5300 may not include a display 5306, but may include display interface circuitry (e.g., a connector and driver circuitry) to which a display 5306 may be coupled. In another set of examples, the electrical device 5300 may not include an audio input device 5318 (e.g., microphone) or an audio output device 5308 (e.g., a speaker, a headset, earbuds, etc.), but may include audio input or output device interface circuitry (e.g., connectors and supporting circuitry) to which an audio input device 5318 or audio output device 5308 may be coupled.

The electrical device 5300 may include programmable circuitry 5302 (e.g., one or more processing devices). The programmable circuitry 5302 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 5300 may include a memory 5304, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 5304 may include memory that shares a die with the programmable circuitry 5302. This memory may be used as cache memory and may include embedded dynamic random access memory (eDRAM) or spin transfer torque magnetic random access memory (STT-MRAM).

In some examples, the electrical device 5300 may include a communication chip 5312 (e.g., one or more communication chips). For example, the communication chip 5312 may be configured for managing wireless communications for the transfer of data to and from the electrical device 5300. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 5312 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 5312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 5312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 5312 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 5312 may operate in accordance with other wireless protocols in other examples. The electrical device 5300 may include an antenna 5322 to facilitate wireless communications and/or to receive other wireless communications (such as AM or FM radio transmissions).

In some examples, the communication chip 5312 may manage wired communications, such as electrical, optical, or any other suitable communication protocols (e.g., the Ethernet). As noted above, the communication chip 5312 may include multiple communication chips. For instance, a first communication chip 5312 may be dedicated to shorter-range wireless communications such as Wi-Fi or Bluetooth, and a second communication chip 5312 may be dedicated to longer-range wireless communications such as global positioning system (GPS), EDGE, GPRS, CDMA, WiMAX, LTE, EV-DO, or others. In some examples, a first communication chip 5312 may be dedicated to wireless communications, and a second communication chip 5312 may be dedicated to wired communications.

The electrical device 5300 may include battery/power circuitry 5314. The battery/power circuitry 5314 may include one or more energy storage devices (e.g., batteries or capacitors) and/or circuitry for coupling components of the electrical device 5300 to an energy source separate from the electrical device 5300 (e.g., AC line power).

The electrical device 5300 may include a display 5306 (or corresponding interface circuitry, as discussed above). The display 5306 may include any visual indicators, such as a heads-up display, a computer monitor, a projector, a touchscreen display, a liquid crystal display (LCD), a light-emitting diode display, or a flat panel display.

The electrical device 5300 may include an audio output device 5308 (or corresponding interface circuitry, as discussed above). The audio output device 5308 may include any device that generates an audible indicator, such as speakers, headsets, or earbuds.

The electrical device 5300 may include an audio input device 5318 (or corresponding interface circuitry, as discussed above). The audio input device 5318 may include any device that generates a signal representative of a sound, such as microphones, microphone arrays, or digital instruments (e.g., instruments having a musical instrument digital interface (MIDI) output).

The electrical device 5300 may include GPS circuitry 5316. The GPS circuitry 5316 may be in communication with a satellite-based system and may receive a location of the electrical device 5300, as known in the art.

The electrical device 5300 may include any other output device 5310 (or corresponding interface circuitry, as discussed above). Examples of the other output device 5310 may include an audio codec, a video codec, a printer, a wired or wireless transmitter for providing information to other devices, or an additional storage device.

The electrical device 5300 may include any other input device 5320 (or corresponding interface circuitry, as discussed above). Examples of the other input device 5320 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 5300 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 5300 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, and articles of manufacture that include glass cores with multiple different types of cavities, holes, and/or openings that may be considerably different in size. Further, example methods have been disclosed that enable the fabrication of such glass cores with multiple different types and/or sizes of cavities, holes, and/or openings during a single LIDE process, thereby avoiding the problems that arise from implementing multiple LIDE processes at different times to produce the different types of cavities, holes, and/or openings. More particularly, in some examples, the different types of openings include through-holes for the TGVs and larger cavities to contain electronic components (e.g., CMILs, capacitors, semiconductor devices, etc.) embedded therein. Further, examples disclosed herein ensure the features and/or structures to be provided in the different types of openings can be fabricated without affecting one another for improved reliability and better yield loss.

Further examples and combinations thereof include the following:
Example 1 includes an apparatus comprising a glass core having a first opening, and a second opening spaced apart from the first opening, the second opening having a greater width than the first opening, a conductive material adjacent a first wall of the first opening, and a dielectric material adjacent a second wall of the second opening.
Example 2 includes the apparatus of example 1, including an electronic component within the second opening, the dielectric material between the electronic component and the second wall of the second opening.
Example 3 includes the apparatus of example 2, wherein the electronic component includes a magnetic material along an inner surface of a round hole in the dielectric material.
Example 4 includes the apparatus of example 3, wherein the conductive material is first conductive material, and the electronic component includes second conductive material within the round hole, the magnetic material separating the second conductive material from the dielectric material.
Example 5 includes the apparatus of example 4, wherein the electronic component includes a non-magnetic plug, the second conductive material separating the non-magnetic plug from the magnetic material.
Example 6 includes the apparatus of any one of examples 3-5, wherein the dielectric material is a first dielectric material, and the apparatus includes a layer of a second dielectric material across at least one of first or second opposing outer surfaces of the glass core, the magnetic material extends through the layer of the second dielectric material.
Example 7 includes the apparatus of any one of examples 1-6, wherein an open space separates at least a portion of the first wall from at least a portion of the conductive material.
Example 8 includes the apparatus of example 7, wherein the open space extends circumferentially at least halfway around the conductive material.
Example 9 includes the apparatus of any one of examples 7 or 8, wherein the open space has a width and a length, the width in a first direction radial to an axis of the first opening, and the length in a second direction parallel to the axis of the first opening, the length of the open space greater than the width of the open space.
Example 10 includes the apparatus of any one of examples 1-9, wherein the dielectric material corresponds to a liquid dispensable material.
Example 11 includes the apparatus of any one of examples 1-10, wherein the dielectric material is a first dielectric material, and the apparatus includes a second dielectric material different from the first dielectric material, the second dielectric material extends across an outer surface of the glass core and across an outer surface of the first dielectric material.
Example 12 includes the apparatus of example 11, wherein the second dielectric material includes an organic laminate dielectric.
Example 13 includes the apparatus of any one of examples 11 or 12, including a third dielectric material lining the first wall of the first opening and lining the second wall of the second opening, the second dielectric material different from the first dielectric material and different from the second dielectric material.
Example 14 includes the apparatus of example 13, wherein the second dielectric material separates the second dielectric material from the glass core.
Example 15 includes an apparatus comprising a first build-up region, a second build-up region, a glass core assembly between the first and second build-up regions, the glass core assembly including: a glass core having a cavity, the cavity having a first width, and a through-glass via extending through the glass core, the through-glass via having a second width, the first width different from the second width, the through-glass via spaced apart from the cavity, and an electronic component within a dielectric material within the cavity.
Example 16 includes the apparatus of example 15, wherein the through-glass via does not include a metal seed layer.
Example 17 includes the apparatus of any one of examples 15 or 16, wherein opposing sidewalls of the cavity are non-parallel.
Example 18 includes the apparatus of any one of examples 15-17, wherein the electronic component includes a coaxial magnetic inductor loop having a conductive material inside a magnetic exterior, the apparatus including a first contact pad electrically coupled to the through-glass via, and a second contact pad electrically coupled to the conductive material of the coaxial magnetic inductor loop, the second contact pad in contact with the magnetic exterior.
Example 19 includes an apparatus comprising a semiconductor chip, a package substrate including a glass layer having a first surface and a second surface opposite the first surface, a first opening in the glass layer, a second opening in the glass layer, the first surface having a first aspect ratio, the second surface having a second aspect ratio, the second aspect ratio greater than the first aspect ratio, a metal substantially filling the first opening, and a coaxial magnetic inductor loop extending through a dielectric material inside the second opening.
Example 20 includes the apparatus of example 19, wherein the dielectric material at least one of (i) abuts a sidewall of the second opening or (ii) abuts a dielectric liner that abuts the sidewall of the second opening.
Example 21 includes a method comprising etching first and second openings in a glass layer, the first opening larger than the second opening, filling the first opening with a dielectric material, filling the second opening with a conductive material, drilling a hole through the dielectric material, and providing an electronic component within the hole in the dielectric material.
Example 22 includes the method of example 21, wherein the filling of the second opening occurs after the filling of the first opening.
Example 23 includes the method of example 22, wherein the drilling of the hole occurs after the filling of the second opening.
Example 24 includes the method of any one of examples 21-23, wherein the filling of the first opening includes dispensing the dielectric material into the first opening in liquid form, and curing the dielectric material.
Example 25 includes the method of any one of examples 21-24, wherein the filling of the second opening is done via a bottom-up plating process.
Example 26 includes the method of any one of examples 21-25, wherein the etching of the first and second openings is implemented during a single laser induced etching process.
Example 27 includes the method of any one of examples 21-26, wherein the providing of the electronic component includes depositing a magnetic material in the hole, the hole being a first hole, drilling a second hole in the magnetic material, and plating a metal within the second hole.
Example 28 includes an apparatus comprising a glass core having a first through-hole and a second through-hole, the first through-hole spaced apart from and smaller than the second through-hole, a conductive material within the first through-hole, and a dielectric material within the second through-hole, the dielectric material between an electronic component within the second through-hole and a sidewall of the second through-hole.
Example 29 includes the apparatus of example 28, wherein the electronic component includes a coaxial magnetic inductor loop.
Example 30 includes the apparatus of example 29, wherein the coaxial magnetic inductor loop includes a first portion and a second portion, the dielectric material between the first and second portions.
Example 31 includes the apparatus of any one of examples 29 or 30, wherein the conductive material is a first conductive material, and the coaxial magnetic inductor loop includes a magnetic material, and a second conductive material inside the magnetic material.
Example 32 includes the apparatus of example 31, wherein the second conductive material extends across a space inside the magnetic material.
Example 33 includes the apparatus of any one of examples 31 or 32, wherein an end of the magnetic material is substantially flush with an outer surface of the glass core.
Example 34 includes the apparatus of any one of examples 28-33, including a gap between an inner surface of the first through-hole and the conductive material, the gap devoid of solid material.
Example 35 includes the apparatus of example 34, wherein the gap extends a majority of a length of the first through-hole.
Example 36 includes the apparatus of any one of examples 28-35, wherein the dielectric material is a first dielectric material, and the apparatus includes a second dielectric material across an outer surface of the glass core and across an outer surface of the first dielectric material.
Example 37 includes the apparatus of example 36, wherein the second dielectric material is a same material as the first dielectric material within the second through-hole.
Example 38 includes the apparatus of any one of examples 36 or 37, wherein the second dielectric material is a different material from the first dielectric material within the second through-hole.
Example 39 includes the apparatus of example 38, wherein the first dielectric material within the second through-hole includes a liquid dispensable material.
Example 40 includes the apparatus of example 39, wherein the second dielectric material includes an organic laminate dielectric.
Example 41 includes the apparatus of any one of examples 36-40, including a third dielectric material that coats the glass core, the third dielectric material different from the first dielectric material within the second through-hole and different from the second dielectric material.
Example 42 includes the apparatus of example 41, wherein the third dielectric material includes silicon.
Example 43 includes an apparatus comprising a glass core having a first hole and a second hole, the second hole larger than the first hole, a first build-up region on a first side of the glass core, a second build-up region on a second side of the glass core, a conductive material in the first hole, the conductive material electrically coupling the first and second build-up regions, and a dielectric material adjacent an inner wall of the second hole, the dielectric material defines a third hole, an electronic component included within the third hole.
Example 44 includes the apparatus of example 43, wherein the glass core includes a tooling hole, the tooling hole including a magnetic material.
Example 45 includes the apparatus of any one of examples 43 or 44, wherein a width of the second hole is multiple times larger than a width of the first hole.
Example 46 includes an apparatus comprising a package substrate including a glass layer, a semiconductor die mounted to the package substrate, a conductive via in the glass layer, an inductor within a cavity of the glass layer, the cavity spaced apart from the conductive via, and a dielectric material between the inductor and a sidewall of the cavity.
Example 47 includes the apparatus of example 46, wherein there is no metal seed layer between the glass layer and the conductive via.
Example 48 includes a method comprising performing a single laser induced etching process to simultaneously create a through-hole and a cavity in a glass core, the through-hole spaced apart from the cavity, depositing a dielectric material within the cavity, plating metal within the through-hole, and providing an electronic component in the dielectric material.
Example 49 includes the method of example 48, wherein the plating of the metal occurs without a seed layer previously deposited in the through-hole.
Example 50 includes the method of example 49, wherein the depositing of the dielectric material occurs before the plating of the metal so that that the dielectric material prevents the metal from entering the cavity.
Example 51 includes the method of any one of examples 48-50, wherein the dielectric material is dispensed into the cavity in liquid form and subsequently cured.
Example 52 includes the method of any one of examples 48-51, wherein the electronic component is a coaxial magnetic loop inductor.
Example 53 includes the method of example 52, wherein the providing of the electronic component includes creating an opening in the dielectric material, adding a magnetic material in the opening, removing a center of the magnetic material, and adding a conductive material in the center of the magnetic material.
Example 54 includes the method of example 53, wherein the adding of the conductive material is accomplished concurrently with the plating of the metal within the through-hole.
Example 55 includes an apparatus comprising a glass layer having a first hole and a second hole, the second hole larger than an electronic component disposed therein, the electronic component larger than the first hole, a conductive material that substantially fills the first hole, and a dielectric material that substantially fills a space within the second hole surrounding the electronic component.
Example 56 includes the apparatus of example 55, wherein the electronic component includes a magnetic material in contact with the dielectric material.
Example 57 includes the apparatus of example 56, wherein the conductive material is a first conductive material, and a first portion of the magnetic material surrounds a first portion of a second conductive material, and a second portion of the magnetic material surrounds a second portion of second conductive material.
Example 58 includes the apparatus of example 57, wherein the second portion of the magnetic material is a continuous extension of the first portion of the magnetic material.
Example 59 includes the apparatus of any one of examples 56-58, wherein an outer surface of the magnetic material is approximately flush with an outer surface of the glass layer.
Example 60 includes the apparatus of example 59, including a dielectric layer across the outer surface of the magnetic material and across the outer surface of the glass layer.
Example 61 includes the apparatus of example 60, wherein the dielectric layer includes a different material from the dielectric material.
Example 62 includes the apparatus of example 61, wherein the dielectric material corresponds to a liquid dispensable material and the dielectric layer corresponds to an organic laminate dielectric.
Example 63 includes the apparatus of any one of examples 55-62, wherein a void is positioned between facing surfaces of the first hole and the conductive material within the first hole.
Example 64 includes the apparatus of example 63, wherein the conductive material is a first conductive material, and the void is a first void, and the electronic component includes a magnetic material surrounding a second conductive material, a second void positioned between facing surfaces of the magnetic material and the second conductive material.
Example 65 includes the apparatus of any one of examples 63 or 64, including a thin film dielectric on the glass layer within the first hole, the void between the thin film dielectric and the conductive material.
Example 66 includes the apparatus of example 65, wherein the thin film dielectric is on the glass layer within the second hole, the thin film dielectric between the dielectric material and a sidewall of the second hole in the glass layer.
Example 67 includes the apparatus of example 66, wherein the thin film dielectric is in contact with the glass layer and in contact with the dielectric material.
Example 68 includes an apparatus comprising a glass layer having an opening extending from a first surface of the glass layer to a second surface of the glass layer, the second surface opposite the first surface, a first redistribution layer adjacent the first surface of the glass layer, a second redistribution layer adjacent the second surface of the glass layer, a metal via extending through the glass layer, the metal via spaced apart from the opening, and a dielectric material extending through the glass layer along a wall of the opening.
Example 69 includes the apparatus of example 68, including a coaxial magnetic loop inductor within the dielectric material.
Example 70 includes the apparatus of example 69, wherein the coaxial magnetic loop inductor includes a coupled coaxial magnetic loop inductor.
Example 71 includes the apparatus of any one of examples 69 or 70, wherein the coaxial magnetic loop inductor includes a conductive core surrounded by a magnetic material, and the apparatus includes a dielectric layer extending across the first surface of the glass layer and a substantially parallel surface of the magnetic material, and a contact pad electrically coupled to the conductive core, the dielectric layer between the magnetic material and the contact pad.
Example 72 includes an apparatus comprising a semiconductor chip, a substrate on which the semiconductor chip is mounted, the substrate including a glass core having a cavity and a through-hole adjacent to the cavity, the cavity larger than the through-hole, a conductive material within the through-hole, a dielectric material within the cavity, the dielectric material including an opening extending therethrough, and a magnetic material within the opening.
Example 73 includes the apparatus of example 72, wherein the magnetic material has a cylindrical shape and is filled with a metal.
Example 74 includes the apparatus of any one of examples 72 or 73, wherein a portion of an exterior surface of the conductive material within the through-hole is separated from a sidewall of the through-hole by a void.
Example 75 includes a method comprising adding a through-hole to a glass core, adding a cavity to the glass core, both the through-hole and the cavity added to the glass core during a same process, the cavity being a different size from the through-hole, depositing a dielectric material within the cavity, depositing a metal within the through-hole, providing an opening in the dielectric material after the metal is deposited within the through-hole, and adding an electronic component into the opening.
Example 76 includes the method of example 75, wherein the depositing of the dielectric material within the cavity occurs before the depositing of the metal within the through-hole.
Example 77 includes the method of any one of examples 75 or 76, wherein the depositing of the dielectric material includes dispensing the dielectric material in liquid form.
Example 78 includes the method of any one of examples 75-77, wherein the depositing of the metal is implemented by a bottom-up plating process without a seed layer.
Example 79 includes the method of any one of examples 75-78, wherein the electronic component is an inductor.
Example 80 includes the method of example 79, wherein the adding of the electronic component includes depositing a magnetic material within the opening, drilling a hole through the magnetic material, and depositing a conductive material within the hole in the magnetic material.
Example 81 includes an apparatus comprising a glass layer having an opening between opposing first and second surfaces of the glass layer, an electronic component within the opening, a dielectric material within the opening between the electronic component and a sidewall of the opening, and a through-glass via including a conductive material that extends through the glass layer.
Example 82 includes the apparatus of example 81, wherein the dielectric material substantially surrounds the electronic component.
Example 83 includes the apparatus of any one of examples 81 or 82, wherein the electronic component includes a capacitor.
Example 84 includes the apparatus of example 83, wherein the capacitor includes a deep trench capacitor.
Example 85 includes the apparatus of any one of examples 81-84, wherein the electronic component includes contact pads, the contact pads substantially flush with the first surface of the glass layer.
Example 86 includes the apparatus of any one of examples 81-85, wherein the electronic component has a first thickness, and the glass layer has a second thickness, the second thickness greater than the first thickness.
Example 87 includes the apparatus of any one of examples 81-86, including a first dielectric layer that extends across the first surface of the glass layer and across a first end of the opening, and a second dielectric layer that extends across the second surface of the glass layer and across a second end of the opening.
Example 88 includes the apparatus of example 87, wherein the dielectric material includes a different material from the first dielectric layer and includes a different material from the second dielectric layer.
Example 89 includes the apparatus of any one of examples 87 or 88, including a thin film that coats the first and second surfaces of the glass layer, the thin film between the glass layer and the first dielectric layer and between the glass layer and the second dielectric layer.
Example 90 includes the apparatus of example 89, wherein the thin film separates the dielectric material within the opening from the glass layer.
Example 91 includes the apparatus of any one of examples 81-90, wherein the dielectric material includes a cured liquid dispensable material.
Example 92 includes the apparatus of any one of examples 81-91, wherein the through-glass via does not include a seed layer along a length of the through-glass via.
Example 93 includes an apparatus comprising a first build-up region, a second build-up region, a glass core between first and second build-up regions, the glass core having first and second openings extending therethrough, the first opening smaller than and spaced apart from the second opening, a metal material along a first wall of the first opening, and a dielectric material along a second wall of the second opening.
Example 94 includes the apparatus of example 93, wherein an outward facing surface of the metal material is spaced apart from the first wall of the first opening.
Example 95 includes the apparatus of any one of examples 93 or 94, wherein an open space extends at least one quarter of a way circumferentially around a cross-sectional perimeter of the metal material within the first opening.
Example 96 includes the apparatus of any one of examples 93-95, wherein an open space extends at least 10% of a length of the first opening.
Example 97 includes the apparatus of any one of examples 93-96, including an electronic component within the dielectric material inside the second opening.
Example 98 includes the apparatus of example 97, where the electronic component includes a deep trench capacitor.
Example 99 includes an apparatus comprising a package substrate including a glass core having a first opening and a second opening larger than the first opening, a conductive material in the first opening, a dielectric material in the second opening, a capacitor in the dielectric material in the second opening, and a semiconductor chip attached to the package substrate.
Example 100 includes the apparatus of example 99, wherein the conductive material in the first opening is separated from a sidewall of the first opening by a gap that is devoid of solid material.
Example 101 includes a method comprising providing a first opening in a glass core, the first opening extending through the glass core, the first opening having a first width, providing a second opening in a glass core, the second opening extending through the glass core, the second opening having a second width, the second width different from the first width, placing an electronic component within the first opening, depositing a dielectric material within the first opening around the electronic component, and depositing a metal within the second opening.
Example 102 includes the method of example 101, wherein the first and second openings are provided in the glass core during a same process.
Example 103 includes the method of any one of examples 101 or 102, wherein the depositing of the dielectric material is implemented by dispensing the dielectric material in liquid form and subsequently curing the dielectric material.
Example 104 includes the method of any one of examples 101-103, wherein the depositing of the metal is implemented by a bottom-up plating process without a seed layer.
Example 105 includes the method of any one of examples 101-104, wherein the electronic component includes a deep trench capacitor.
The following section of the description relates to further examples. The numbered paragraphs in this section are not claims. The claims are set forth below in the later section headed "claims".
The claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

### CLAUSES

1. An apparatus comprising:
   a glass layer having an opening between opposing first and second surfaces of the glass layer;
   an electronic component within the opening;
   a dielectric material within the opening between the electronic component and a sidewall of the opening; and
   a through-glass via including a conductive material that extends through the glass layer.
2. The apparatus of clause 1, wherein the dielectric material substantially surrounds the electronic component.
3. The apparatus of clause 1, wherein the electronic component includes a capacitor.
4. The apparatus of clause 3, wherein the capacitor includes a deep trench capacitor.
5. The apparatus of clause 1, wherein the electronic component includes contact pads, the contact pads substantially flush with the first surface of the glass layer.
6. The apparatus of clause 1, wherein the electronic component has a first thickness, and the glass layer has a second thickness, the second thickness greater than the first thickness.
7. The apparatus of clause 1, including:
   a first dielectric layer that extends across the first surface of the glass layer and across a first end of the opening; and
   a second dielectric layer that extends across the second surface of the glass layer and across a second end of the opening.
8. The apparatus of clause 7, wherein the dielectric material includes a different material from the first dielectric layer and includes a different material from the second dielectric layer.
9. The apparatus of clause 7, including a thin film that coats the first and second surfaces of the glass layer, the thin film between the glass layer and the first dielectric layer and between the glass layer and the second dielectric layer.
10. The apparatus of clause 9, wherein the thin film separates the dielectric material within the opening from the glass layer.
11. The apparatus of clause 1, wherein the dielectric material includes a cured liquid dispensable material.
12. The apparatus of clause 1, wherein the through-glass via does not include a seed layer along a length of the through-glass via.
13. An apparatus comprising:
   a first build-up region;
   a second build-up region;
   a glass core between first and second build-up regions, the glass core having first and second openings extending therethrough, the first opening smaller than and spaced apart from the second opening;
   a metal material along a first wall of the first opening; and
   a dielectric material along a second wall of the second opening.
14. The apparatus of clause 13, wherein an outward facing surface of the metal material is spaced apart from the first wall of the first opening.
15. The apparatus of clause 13, wherein an open space extends at least one quarter of a way circumferentially around a cross-sectional perimeter of the metal material within the first opening.
16. The apparatus of clause 13, wherein an open space extends at least 10% of a length of the first opening.
17. The apparatus of clause 13, including an electronic component within the dielectric material inside the second opening.
18. The apparatus of clause 17, where the electronic component includes a deep trench capacitor.
19. An apparatus comprising:
   a package substrate including a glass core having a first opening and a second opening larger than the first opening;
   a conductive material in the first opening;
   a dielectric material in the second opening;
   a capacitor in the dielectric material in the second opening; and
   a semiconductor chip attached to the package substrate.
20. The apparatus of clause 19, wherein the conductive material in the first opening is separated from a sidewall of the first opening by a gap that is devoid of solid material.
21. A method comprising:
   providing a first opening in a glass core, the first opening extending through the glass core, the first opening having a first width;
   providing a second opening in a glass core, the second opening extending through the glass core, the second opening having a second width, the second width different from the first width;
   placing an electronic component within the first opening;
   depositing a dielectric material within the first opening around the electronic component; and
   depositing a metal within the second opening.
22. The method of clause 21, wherein the first and second openings are provided in the glass core during a same process.
23. The method of clause 21, wherein the depositing of the dielectric material is implemented by dispensing the dielectric material in liquid form and subsequently curing the dielectric material.
24. The method of clause 21, wherein the depositing of the metal is implemented by a bottom-up plating process without a seed layer.
25. The method of clause 21, wherein the electronic component includes a deep trench capacitor.

## Claims

1. An apparatus comprising:
a glass layer having an opening between opposing first and second surfaces of the glass layer;
an electronic component within the opening;
a dielectric material within the opening between the electronic component and a sidewall of the opening;
and
a through-glass via including a conductive material that extends through the glass layer.

2. The apparatus of claim 1, wherein the dielectric material substantially surrounds the electronic component.

3. The apparatus of any one of claims 1-2, wherein the electronic component includes a capacitor.

4. The apparatus of claim 3, wherein the capacitor includes a deep trench capacitor.

5. The apparatus of any one of claims 1-4, wherein the electronic component includes contact pads, the contact pads substantially flush with the first surface of the glass layer.

6. The apparatus of any one of claims 1-5, wherein the electronic component has a first thickness, and the glass layer has a second thickness, the second thickness greater than the first thickness.

7. The apparatus of any one of claims 1-6, including:
a first dielectric layer that extends across the first surface of the glass layer and across a first end of the opening; and
a second dielectric layer that extends across the second surface of the glass layer and across a second end of the opening.

8. The apparatus of claim 7, wherein the dielectric material includes a different material from the first dielectric layer and includes a different material from the second dielectric layer.

9. The apparatus of any one of claims 7-8, including a thin film that coats the first and second surfaces of the glass layer, the thin film between the glass layer and the first dielectric layer and between the glass layer and the second dielectric layer.

10. The apparatus of claim 9, wherein the thin film separates the dielectric material within the opening from the glass layer.

11. The apparatus of any one of claims 1-10, wherein the dielectric material includes a cured liquid dispensable material.

12. The apparatus of any one of claims 1-11, wherein the through-glass via does not include a seed layer along a length of the through-glass via.

13. A method comprising:
providing a first opening in a glass core, the first opening extending through the glass core, the first opening having a first width;
providing a second opening in a glass core, the second opening extending through the glass core, the second opening having a second width, the second width different from the first width;
placing an electronic component within the first opening;
depositing a dielectric material within the first opening around the electronic component; and
depositing a metal within the second opening.

14. The method of claim 13, wherein the first and second openings are provided in the glass core during a same process.

15. The method of any one of claims 13-14, wherein the depositing of the metal is implemented by a bottom-up plating process without a seed layer.
